(19) **Europäisches Patentamt**
**European Patent Office**
**Office européen des brevets**

(11) **EP 3 654 462 B1**

(12) **FASCICULE DE BREVET EUROPEEN**

(45) Date de publication et mention
de la délivrance du brevet:
**15.09.2021 Bulletin 2021/37**

(51) Int Cl.:
*H01S 3/07* (2006.01)          *H01S 5/02* (2006.01)
*H01S 5/026* (2006.01)         *H01S 5/065* (2006.01)
*H01S 5/10* (2021.01)          *H01S 5/125* (2006.01)
*H01S 5/14* (2006.01)

(21) Numéro de dépôt: **19207661.0**

(22) Date de dépôt: **07.11.2019**

(54) **SOURCE LASER A SEMI-CONDUCTEUR ET PROCEDE D'EMISSION AVEC CETTE SOURCE LASER**

LASERQUELLE MIT HALBLEITER UND EMISSIONSVERFAHREN MIT DIESER LASERQUELLE

LASER SOURCE WITH SEMICONDUCTOR AND TRANSMISSION METHOD WITH SAID LASER SOURCE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.11.2018 FR 1860520**

(43) Date de publication de la demande:
**20.05.2020 Bulletin 2020/21**

(73) Titulaire: **Commissariat à l'Énergie Atomique et aux Énergies Alternatives
75015 Paris (FR)**

(72) Inventeurs:
• **WILMART, Quentin**
**38054 GRENOBLE cedex 09 (FR)**
• **HASSAN, Karim**
**38054 GRENOBLE cedex 09 (FR)**

(74) Mandataire: **Colombo, Michel
Innovation Competence Group
310, avenue Berthelot
69372 Lyon Cedex 08 (FR)**

(56) Documents cités:
WO-A1-2007/107187     CN-B- 103 368 678
US-A1- 2003 123 784    US-A1- 2012 057 079
US-A1- 2014 254 617    US-A1- 2016 301 191

**Description**

L'invention concerne une source laser à semi-conducteur et un procédé d'émission d'un signal optique à une longueur d'onde $\lambda_{Li}$ proche d'une longueur d'onde $\lambda_{Si}$ souhaitée.

Des sources lasers connues à semi-conducteur comportent :

- un ensemble de guides d'onde optiquement couplés les uns aux autres et formant une cavité optique apte à faire résonner un signal optique à plusieurs fréquences de résonance possibles, les longueurs d'onde possibles $\lambda_{Rj}$ de ces fréquences de résonance possibles étant régulièrement espacées les unes des autres par un intervalle $\Delta\lambda_R$, cet ensemble comportant :

  • au moins un guide d'onde dans lequel est réalisé un filtre passe-bande, le spectre de transmission de ce filtre passe-bande comportant une bande passante apte à sélectionner, parmi les différentes longueurs d'onde $\lambda_{Rj}$ possibles, la longueur d'onde $\lambda_{Li}$ la plus proche de la longueur d'onde $\lambda_{Si}$, et
  • au moins un guide d'onde à gain apte à générer du gain optique à chaque longueur d'onde $\lambda_{Li}$ sélectionnée par le filtre passe-bande, ce guide d'onde à gain comportant un matériau à gain III-V.

Par exemple, une telle source laser connue est divulguée dans la demande US2018261976A.

De l'état de la technique est également connu de US20140254617A1, US20030123784A1, CN103368678B, US2016301191A1, US2012057079A1 et WO2007107187 A1.

La demande US20140254617A1 divulgue une filtre passe-bande contenant un interféromètre de Mach-Zehnder. Toutefois, les bras de l'interféromètre de Mach-Zehnder sont dépourvus de sections à gain.

La demande US20030123784A1 divulgue un démultiplexeur multi-modes utilisant un interféromètre.

La demande CN103368678B décrit un interrupteur optique utilisant un interféromètre de Mach-Zender. Cet interrupteur optique est dépourvu de cavité résonante.

Il est connu que la longueur d'onde $\lambda_{Li}$ d'une source laser à semi-conducteur varie en fonction de la température. Il est souhaitable de limiter autant que possible cette variation. De nombreuses solutions ont déjà été proposées pour limiter cette variation. Par exemple, dans la demande US2018261976A, le filtre passe-bande de la source laser est réalisé en nitrure de silicium pour limiter autant que possible cette variation. Toutefois, la fabrication du filtre passe-bande dans du nitrure de silicium complexifie la fabrication de la source laser.

Il est également souhaitable de limiter autant que possible l'encombrement de tel source laser à semi-conducteur et de simplifier leur réalisation.

L'invention vise à proposer une architecture pour la source laser qui minimise la longueur de la cavité résonnante sans pour autant réduire la puissance du signal optique émis. En tant qu'objectif secondaire, l'invention vise également à proposer une source laser dont les variations de la longueur d'onde $\lambda_{Li}$ d'émission en fonction de la température sont limitées sans que pour cela il soit nécessaire de réaliser le filtre passe-bande dans un autre matériau que du silicium.

Elle a donc pour objet une source laser à semi-conducteur conforme à la revendication 1.

Les modes de réalisation de cette source laser peuvent comporter une ou plusieurs des caractéristiques des revendications dépendantes.

L'invention a également pour objet un procédé d'émission d'un signal optique à une longueur d'onde $\lambda_{Li}$ proche d'une longueur d'onde $\lambda_{Si}$ souhaitée.

L'invention sera mieux comprise à la lecture de la description qui va suivre, donnée uniquement à titre d'exemple non-limitatif et faite en se référant aux dessins sur lesquels :

- la figure 1 est une illustration schématique, en vue de dessus, de l'architecture d'une source laser à semi-conducteur ;
- la figure 2 est une illustration schématique en coupe verticale de la source laser de la figure 1 ;
- la figure 3 est un graphe illustrant le spectre de transmission d'un filtre passe-bande de la source laser de la figure 1 ;
- les figures 4, 5, 8, 10, 11, 13 et 15 sont des illustrations schématiques, en vue de dessus, de différents autres architectures possibles de la source laser de la figure 1 ;
- les figures 6 et 7 sont des graphes illustrant des spectres de transmission de filtres de la source laser de la figure 5 ;
- la figure 9 est un graphe illustrant le spectre de transmission de filtres de la source laser de la figure 8 ;
- la figure 12 est un organigramme d'un procédé d'émission d'un signal optique à une longueur d'onde $\lambda_{Li}$ à l'aide de la source laser de la figure 11 ;
- la figure 14 est un graphe illustrant le spectre de transmission de filtres de la source laser de la figure 13.

Dans ces figures, les mêmes références sont utilisées pour désigner les mêmes éléments. Dans la suite de cette description, les caractéristiques et fonctions bien connues de l'homme du métier ne sont pas décrites en détail.

Chapitre I : Définitions et notations

La longueur d'onde $\lambda_{Li}$ est la longueur d'onde à laquelle émet la source laser. Lorsque la source laser est une source laser monomode ou monochromatique, il n'existe qu'une seule longueur d'onde $\lambda_{Li}$. Lorsque la source laser est une source laser multimode ou polychromatique, il existe simultanément plusieurs longueurs d'onde $\lambda_{Li}$ différentes. Dans ce dernier cas, l'indice i est un identifiant de la longueur d'onde $\lambda_{Li}$ parmi les différentes longueurs d'onde auxquelles la source laser émet. Typiquement, la longueur d'onde $\lambda_{Li}$ est comprise entre 1250 nm et 1590 nm.

Les longueurs d'onde $\lambda_{Rj}$ sont les différentes longueurs d'onde auxquelles une cavité résonante est susceptible de résonner en absence de filtre passe-bande. Le filtre passe-bande est le filtre qui sélectionne un nombre réduit de longueurs d'onde $\lambda_{Rj}$. Ces longueurs d'ondes $\lambda_{Rj}$ sont régulièrement espacées les unes des autres par un intervalle $\Delta\lambda_R$. L'indice j est un identifiant d'une longueur d'onde $\lambda_{Rj}$ particulière.

L'intervalle $\Delta R$ est la plus petite plage de longueurs d'onde contenant toutes les longueurs d'onde $\lambda_{Rj}$ possibles. Typiquement, lorsque la cavité résonnante est délimitée par des réflecteurs de signaux optiques, l'intervalle $\Delta R$ est égal à la bande réfléchissante de ces réflecteurs. L'intervalle $\Delta R$ peut aussi être limité par la largeur de la bande d'amplification ou « bande de gain » de l'amplificateur optique utilisé pour amplifier les signaux optiques qui résonnent à l'intérieur de la cavité. La bande de gain est une bande de fréquences qui contient toutes les fréquences des signaux optiques susceptibles d'être amplifiés par l'amplificateur optique. Les signaux optiques dont les fréquences sont en-dehors de cette bande de gain ne sont pas amplifiés par l'amplificateur optique.

La bande réfléchissante d'un réflecteur est la bande réfléchissante à -3 dB. Il s'agit de la plage de longueurs d'onde contenant toutes les longueurs d'onde $\lambda_{Rj}$ aptes à être réfléchies par le réflecteur avec une puissance supérieure ou égale à 50 % de la puissance maximale $I_{max}$ réfléchie par ce réflecteur. La puissance $I_{max}$ est égale à la puissance du signal optique réfléchi pour la longueur d'onde $\lambda_{Rj}$ pour laquelle cette puissance est maximale.

La longueur d'onde $\lambda_{CR}$ est une longueur d'onde correspondant à un maximum du spectre de réflexion du réflecteur. Typiquement, la longueur d'onde $\lambda_{CR}$ est la longueur d'onde située au milieu de la bande réfléchissante du réflecteur. Cette longueur d'onde $\lambda_{CR}$ se déplace en même temps que la bande réfléchissante se déplace.

Ici, les largeurs des bandes passantes sont les largeurs des bandes passantes à - 3dB. Par la suite, la largeur de la bande passante d'un filtre est notée $\Delta\lambda_{FX}$, où l'indice FX est un identifiant du filtre.

On note $\lambda_{CFX}$ la longueur d'onde correspond à un maximum dans le spectre de transmission d'un filtre, où l'indice FX est un identifiant du filtre. Typiquement, la longueur d'onde $\lambda_{CFX}$ est la longueur d'onde située au milieu d'une bande passante du filtre.

On note $d_{FSRX}$ la distance entre les maximums de deux bandes passantes successives du spectre de transmission d'un filtre passe bande, où l'indice FX est un identifiant du filtre. Cette distance est connue sous l'acronyme FSR (« Free Spectral Range »).

Par filtre « athermique », on désigne le fait que le coefficient $d\lambda_{CFC}/dT$ associé à ce filtre est compris entre $L_{min}$ et $L_{max}$, où :

- $\lambda_{CFX}$ est la longueur d'onde correspond à un maximum dans le spectre de transmission du filtre,
- le coefficient $d\lambda_{CFX}/dT$ est la variation de la longueur d'onde $\lambda_{CFX}$ en fonction de la température,
- $L_{min}$ est égale à -50 pm/°C et, de préférence, égale à -15 pm/°C ou -7 pm/°C, et
- $L_{max}$ est égale à +50 pm/°C et, de préférence, égale à +15 pm/°C ou +7 pm/°C.

Pour un filtre donné, le coefficient $d\lambda_{CFX}/dT$ peut être déterminé expérimentalement ou par simulation numérique. Par exemple, la variation de la longueur d'onde $\lambda_{CFX}$ en fonction de la température est mesurée ou simulée sur une plage de température allant de 20°C à 100°C. Typiquement, la longueur d'onde $\lambda_{CFX}$ varie approximativement linéairement en fonction de la température sur cette plage de températures. Il est donc possible d'approximer la relation qui relie la longueur d'onde $\lambda_{CFX}$ à la température T sur cette plage à l'aide de la relation linéaire suivante : $\lambda_{CFX} = aT +b$, où les coefficients a et b sont des constantes. Les valeurs des coefficients a et b sont établies en déterminant la droite qui minimise les écarts, par exemple au sens des moindres carrés, entre cette droite et chaque point mesuré ou simulé. Chaque point mesuré ou simulé a pour abscisse une température et pour ordonnée la longueur d'onde $\lambda_{CFX}$ mesurée ou obtenue par simulation pour cette température. La valeur du coefficient $d\lambda_{CFX}/dT$ est alors prise égale à la valeur du coefficient a.

Le coefficient thermo-optique d'un matériau est le coefficient $dn_r/dT$, où :

- $n_r$ est l'indice de réfraction de ce matériau à la longueur d'onde $\lambda_{Si}$, et
- $dn_r/dT$ est la variation de l'indice de réfraction $n_r$ en fonction de la température sur une plage de température allant de 20°C à 100°C.

De façon similaire à ce qui a été indiqué pour le coefficient $d\lambda_{CFX}/dT$, le coefficient $dn_r/dT$ est approximé par une constante sur la plage de températures allant de 20°C à 100°C.

Chapitre II : Exemples de modes de réalisation

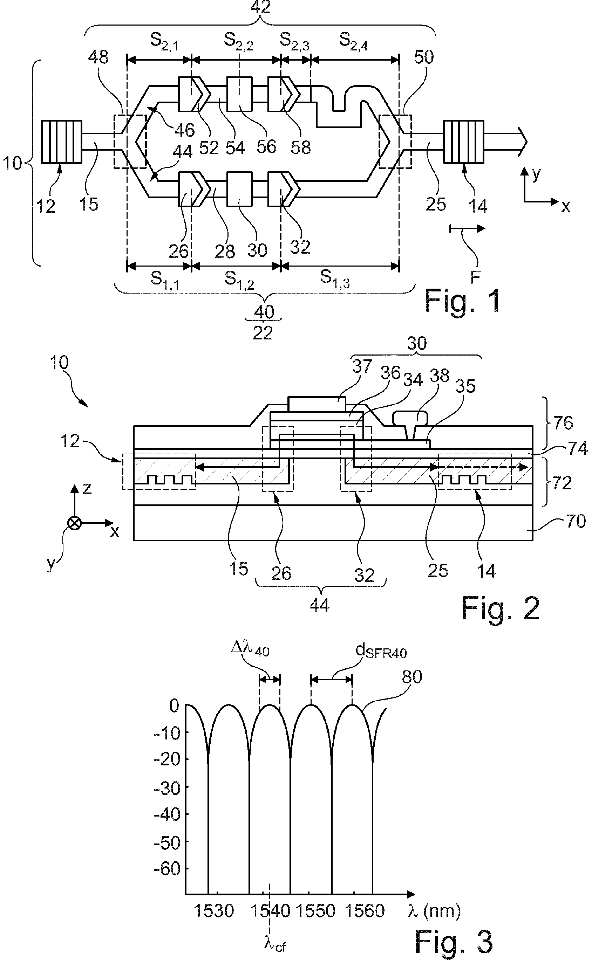

La figure 1 représente schématiquement l'architecture générale d'une source laser 10 à semi-conducteur qui émet à au moins une longueur d'onde $\lambda_{Li}$ aussi proche que possible d'une longueur d'onde $\lambda_{Si}$ souhaitée. La longueur d'onde $\lambda_{Si}$ est constante et soit réglée une fois pour toute lors de la conception de la source laser soit réglable par un utilisateur. Dans tous les cas, une fois réglée, la longueur d'onde $\lambda_{Si}$ reste constante tant que les réglages de la source laser ne sont pas modifiés.

Par la suite, seules les particularités de la source laser 10 sont décrites en détail. Pour des informations générales sur la réalisation et le fonctionnement d'une source laser à semi-conducteur utilisant des guides d'onde en silicium et en matériau à gain III-V, le lecteur peut consulter l'article suivant : B. Ben Bakir et al., « Hybrid Si/III-V lasers with adiabatic coupling », 2011.

La source laser 10 comporte un réflecteur arrière 12 et un réflecteur avant 14 qui définissent les extrémités d'une cavité résonante de Fabry-Pérot. A l'intérieur de cette cavité un signal optique peut résonner, en absence de filtre passe-bande, à plusieurs longueur d'onde possibles $\lambda_{Rj}$. Les longueurs d'onde $\lambda_{Rj}$ sont régulièrement espacées les unes des autres par un intervalle $\Delta\lambda_R$. Dans ce mode de réalisation, l'intervalle $\Delta R$ qui contient toutes les longueur d'onde $\lambda_{Rj}$ est égale à la bande réfléchissante des réflecteurs 12 et 14.

Par exemple, le réflecteur 12 présente un facteur de réflexion strictement supérieur à celui du réflecteur 14. Le facteur de réflexion est égal au rapport entre la puissance du signal optique réfléchi par le réflecteur sur la puissance du signal optique incident sur ce réflecteur. Typiquement, le facteur de réflexion du réflecteur 12 est supérieur ou égal à 90 % ou 95 % pour la longueur d'onde $\lambda_{Li}$. Le facteur de réflexion du réflecteur 14 est généralement compris entre 30 % et 80 % et vaut typiquement 50 %.

Les réflecteurs 12 et 14 sont des réflecteurs large bande. Dans ce mode de réalisation, cela signifie que la largeur de la bande réfléchissante des réflecteurs 12 et 14 est supérieure à une limite inférieure prédéterminée. Cette limite inférieure est ici :

- égale à $\Delta\lambda_f + DT.(d\lambda_{CR}/dT)$ si le filtre passe-bande est agencé pour sélectionner uniquement une seule longueur d'onde $\lambda_{Li}$, et

- égale à $\Delta\lambda_f + \max\{DT.(d\lambda_{CR}/dT) ; N.d_{SFRf} + DT.(d\lambda_{Cf}/dT)\}$ si le filtre passe-bande est agencé pour sélectionner N longueurs d'onde $\lambda_{Li}$,

où :

- $\Delta\lambda_f$ est la largeur de la bande passante du filtre passe-bande de la source laser,
- $DT$ est la largeur d'une gamme prédéterminée de températures de fonctionnement pour la source laser,
- $d\lambda_{CR}/dT$ est la variation de la longueur d'onde centrale $\lambda_{CR}$ des réflecteurs en fonction de la température exprimée en nm/°C,
- $d\lambda_{Cf}/dT$ est la variation de la longueur d'onde centrale $\lambda_{Cf}$ du filtre passe-bande en fonction de la température exprimée en nm/°C,
- $N$ est un nombre entier supérieur ou égal à deux,
- $d_{SFRf}$ est l'intervalle entre deux bandes passantes successives du filtre passe-bande exprimée en nanomètre,
- le symbole « . » désigne dans cette description l'opération de multiplication scalaire, et
- $\max\{...\}$ est la fonction qui retourne le plus grand des éléments situés entre les accolades et séparés les uns des autres par un point virgule.

Différents modes de réalisation du filtre passe-bande de la source laser sont décrits plus loin.

La gamme de températures de fonctionnement d'une source laser est souvent choisie supérieure à 10°C ou 30°C. Ici la gamme de températures de fonctionnement est choisie comme étant comprise entre +20°C et +100°C. La largeur $DT$ est donc ici égale à 80 °C. Par la suite, la plus petite et la plus grande températures de la gamme de températures de fonctionnement sont notées, respectivement, $T_{min}$ et $T_{max}$. Dans ce mode de réalisation, les réflecteurs 12 et 14 sont réalisés dans un guide d'onde dont le cœur est en silicium. Ainsi, la variation $d\lambda_{CR}/dT$ est ici égale à 0,07 nm/°C. Typiquement, la largeur de la bande réfléchissante est supérieure à 6 nm ou 15 nm ou 30 nm.

Les réflecteurs 12 et 14 sont également conçus pour que, à la température $T_{min}$, la longueur d'onde $\lambda_{Li}$ soit plus proche de la borne supérieure $\lambda_{Rmax}$ de la bande réfléchissante des réflecteurs 12 et 14 que de sa borne inférieure $\lambda_{Rmin}$. Par exemple, à la température $T_{min}$, la longueur d'onde $\lambda_{Li}$ est comprise entre 0,9 $\lambda_{Rmax}$ et $\lambda_{Rmax}$. Cette contrainte peut être relâchée si la largeur de la bande réfléchissante est très supérieure à sa limite inférieure telle que définie précédemment.

Ici, les réflecteurs 12 et 14 sont par exemple des réseaux de Bragg.

Entre les réflecteurs 12 et 14, la source laser comporte successivement les composants photoniques suivants en allant du réflecteur 12 vers le réflecteur 14 :

- un guide d'onde optique 15 en silicium dans lequel est réalisé le réflecteur 12,
- un filtre passe-bande 22 apte à sélectionner la longueur d'onde $\lambda_{Li}$ de fonctionnement de la source laser 10 parmi les différentes longueurs d'onde $\lambda_{Rj}$ possibles à l'intérieur de la cavité de Fabry-Pérot,
- un coupleur 26 qui raccorde optiquement le guide d'onde 15 à une entrée d'un guide d'onde 28 en matériau à gain III-V,
- un amplificateur optique 30 à semi-conducteur plus connu sous l'acronyme SOA (« Semiconductor Optical Amplifier ») réalisé dans le guide d'onde 28 et apte à générer et à amplifier le signal optique résonant à l'intérieur de la cavité de Fabry-Pérot à chaque longueur d'onde $\lambda_{Rj}$,
- un coupleur 32 qui raccorde optiquement une sortie du guide d'onde 28 à un guide d'onde 25, et
- le guide d'onde optique 25 en silicium dans lequel est réalisé le réflecteur 14.

Ici, par guide d'onde en silicium, on désigne un guide d'onde dont le cœur est réalisé en silicium. Par exemple, la gaine des guides d'onde en silicium est réalisée dans un autre matériau comme, typiquement, de l'oxyde de silicium.

Les coupleurs 26 et 32 sont par exemple des coupleurs adiabatiques. Pour une description détaillée d'un coupleur adiabatique, le lecteur est renvoyé à l'article suivant: Amnon Yariv et al., « Supermode Si/III-V hybrid Lasers, optical amplifiers and modulators: proposai and analysis » Optics Express 9147, vol. 14, No. 15, 23/07/2007.

Un tel coupleur adiabatique est, par exemple, obtenu en modifiant la largeur du guide d'onde en silicium par rapport à la largeur du guide d'onde en matériau à gain III-V Typiquement pour un couplage adiabatique d'un guide d'onde en silicium vers un guide d'onde en matériau III-V, la largeur du guide d'onde en silicium est progressivement réduite à l'approche du guide d'onde en matériau III-V. En sens inverse, pour transférer par couplage adiabatique un signal optique du guide d'onde en matériau III-V vers un guide d'onde en silicium, la largeur du guide d'onde en silicium est par exemple progressivement augmentée. De plus, typiquement vers le milieu du coupleur adiabatique, les dimensions des sections transversales des guides d'onde en silicium et en matériau III-V sont généralement telles que leurs indices effectifs respectifs sont égaux. Ceci est aussi vrai pour un couplage adiabatique entre des guides d'onde hybrides Si/ matériau III-V.

De préférence, l'amplificateur 30 est un amplificateur large bande, c'est-à-dire capable de générer et d'amplifier une plage importante de longueurs d'onde. Cette plage comprend la longueur d'onde $\lambda_{Si}$. Typiquement, elle est centrée sur cette longueur d'onde $\lambda_{Si}$ à la température $(T_{max}+T_{min})/2$. La largeur de cette plage de longueur d'onde à -3 dB est par exemple d'au moins 10 nm ou 25 nm ou 35nm et reste large avec l'augmentation de température. Par exemple, les matériaux III-V constituant l'amplificateur 30 sont ceux décrits dans l'article suivant : Dimitris Fitsios et al. « High-gain 1,3 $\mu$m GaInNAs semiconductor optical amplifier with enchanced temperature stability for all-optical processing at 10 Gb/s », Applied optics, may 2015 vol. 54, n°1, 1er janvier 2015. Le fait de réaliser l'amplificateur 30 comme décrit dans cet article permet en plus d'obtenir un amplificateur large bande stable en température. Cela améliore le fonctionnement de la source laser et notamment cela permet de maintenir une puissance émise par la source laser presque constante dans toute la gamme de températures de fonctionnement $[T_{min} ; T_{max}]$. Dans ce cas, le guide d'onde 28 et l'amplificateur 30 se présentent sous la forme d'un empilement 34 (Figure 2) de sous-couches en alternance en GaInNAs et en GaNAs interposées entre une sous-couche inférieure 35 (Figure 2) et une sous-couche supérieure 36 (Figure 2) en GaAs dopé P. La sous-couche 35 est une sous-couche en matériau III-V de dopage opposé à la sous couche supérieure 36. Ici, il s'agit d'une sous-couche en GaAs dopé N.

L'amplificateur 30 comporte, en plus du guide d'onde 28, une prise 37 (Figure 2) directement en contact mécanique et électrique avec la portion de la sous-couche 35. La sous-couche 36 est en contact mécanique et électrique avec une prise 38 (Figure 2) pour raccorder électriquement la partie inférieure de l'amplificateur 30 à un potentiel. Lorsqu'un courant continu, appelé « courant d'injection », supérieur au courant de seuil du laser est appliqué entre les prises 37 et 38, l'amplificateur 30 génère et amplifie le signal optique qui résonne à l'intérieur de la cavité de Fabry-Pérot.

Dans ce mode de réalisation, le filtre 22 comporte seulement un filtre primaire athermique 40. Le filtre 40 est ici composé d'un interféromètre 42 de Mach-Zehnder.

L'interféromètre 42 comporte :

- deux bras 44 et 46 aptes chacun à guider le signal optique résonnant, et
- deux embranchements 48 et 50.

Dans le sens de propagation F (Figure 1) du signal optique qui va du réflecteur 12 vers le réflecteur 14, l'embranchement 48 répartit à parts égales le signal optique réfléchi par le réflecteur 12 dans les bras 44 et 46.

Sur la figure 1 et les suivantes, la direction verticale est représentée par une direction Z d'un repère orthogonal XYZ, où X et Y sont des directions horizontales. Ici, la direction X est essentiellement parallèle au sens F de propagation du signal optique.

Dans le sens F, l'embranchement 50 combine les signaux optiques issus des bras 44 et 46 entre eux pour obtenir un signal optique qui se propage dans le guide d'onde 25 vers le réflecteur 14. Dans le sens de propagation opposé au sens F, les rôles des embranchements 48 et 50 sont intervertis. Par exemple, les embranchements 48 et 50 sont des MMI (Multi-Mode Interferometers).

Le bras 44 est divisé en trois sections $S_{1,1}$, $S_{1,2}$ et $S_{1,3}$ consécutives en allant dans le sens F. Par la suite, on désigne par $S_{m,n}$ la section n du bras m, où :

- l'indice m est un identifiant du bras de l'interféromètre, et
- l'indice n est un identifiant de la section de ce bras.

Dans ce texte, lorsque l'indice m est égal à 1, cela désigne le bras inférieur 44. Lorsque l'indice m est égal à 2, cela désigne le bras supérieur 46. L'indice n est le numéro d'ordre de la section en partant de l'embranchement 48 et en allant dans le sens F. Ainsi, un indice n égal à 1 correspond à la première section rencontrée après l'embranchement 48, l'indice n égal à 2 correspond à la deuxième section rencontrée en partant de l'embranchement 48 et ainsi de suite.

Chaque section $S_{m,n}$ est un guide d'onde. Chacune de ces sections présente donc un indice effectif $Neff_{m,n}$ et une longueur $L_{m,n}$ non nulle. Typiquement, chaque section diffère de la section qui la précède et de la section qui la suit par :

- les dimensions de sa section transversale,
- le ou les matériaux utilisés pour réaliser son cœur, et/ou
- le ou les matériaux utilisés pour réaliser sa gaine.

L'indice effectif d'un guide d'onde dépend des matériaux utilisés pour former le cœur et la gaine de ce guide d'onde et aussi des dimensions du cœur et notamment de la largeur et de l'épaisseur du cœur. Les indices effectifs de deux sections successives dans le sens F sont donc différents. Ici, l'indice effectif $Neff_{m,n}$ de chaque section $S_{m,n}$ est considéré comme constant sur toute sa longueur $L_{m,n}$.

L'indice effectif d'un guide d'onde peut être déterminé, pour une température donnée et pour une longueur d'onde donnée, par simulation numérique ou expérimentalement. Ici, lorsque les indices effectifs de différentes sections sont comparés, il s'agit des indices effectifs déterminés pour la même température et la même longueur d'onde. Typiquement, cette longueur d'onde est égale à $\lambda_{Si}$.

L'indice effectif d'un guide d'onde varie en fonction de la température de ce guide d'onde. Par la suite, on note $dneff_{m,n}/dT$ le coefficient qui exprime le taux de variation de l'indice $neff_{m,n}$ de la section $S_{m,n}$ en fonction de la température. En première approximation, sur la plage de températures DT, ce coefficient $dneff_{m,n}/dT$ est considéré comme constant.

Ici, la section $S_{1,1}$ s'étend de l'embranchement 48 jusqu'au coupleur 26. La section $S_{1,1}$ est un guide d'onde en silicium.

La section $S_{1,2}$ s'étend du coupleur 26 jusqu'au coupleur 32. La section $S_{1,2}$ correspond donc au guide d'onde 28 en matériaux à gain III-V dans lequel est réalisé l'amplificateur 30. La section $S_{1,2}$ est appelée ici « section à gain » car elle a la capacité d'amplifier le signal optique.

La section $S_{1,3}$ s'étend du coupleur 32 jusqu'à l'embranchement 50. La section $S_{1,3}$ est un guide d'onde en silicium identique au guide d'onde en silicium de la section $S_{1,1}$ sauf que la longueur $L_{1,3}$ peut être différente de la longueur $L_{1,1}$.

Le bras 46 est divisé en quatre sections consécutives $S_{2,1}$, $S_{2,2}$, $S_{2,3}$ et $S_{2,4}$ en allant dans le sens F. Les sections $S_{2,1}$ et $S_{2,2}$ sont identiques, respectivement, aux sections $S_{1,1}$ et $S_{1,2}$. Le bras 46 comporte donc, comme le bras 44 :

- un coupleur optique 52 qui raccorde optiquement le guide d'onde 15 à une entrée d'un guide d'onde 54 en matériaux à gain III-V,
- un amplificateur optique 56 réalisé dans le guide d'onde 54, et
- un coupleur optique 58 qui raccorde optiquement une sortie du guide d'onde 54 au guide d'onde 25.

Les coupleurs 52, 58, le guide d'onde 54 et l'amplificateur 56 sont identiques, respectivement, aux coupleurs 26, 32, au guide d'onde 28 et à l'amplificateur 30. De plus, le courant d'injection qui traverse l'amplificateur 56 présente ici systématiquement la même intensité que le courant d'injection qui traverse au même instant l'amplificateur 30. Par exemple, pour cela, les sous-couches inférieure 35 et supérieure 36 de l'amplificateur 30 et de l'amplificateur 56 sont communes à ces deux amplificateurs ou directement raccordées électriquement l'une à l'autre. Dans ces conditions, les indices $neff_{1,2}$ et $neff_{2,2}$ sont identiques et les coefficients $dneff_{1,2}/dT$ et $dneff_{2,2}/dT$ sont également identiques.

La section $S_{2,4}$ est identique à la section $S_{1,3}$ sauf que sa longueur $L_{2,4}$ est supérieure à la longueur $L_{1,3}$. Sur la figure 1, le fait que la longueur $L_{2,4}$ est supérieure à la longueur $L_{1,3}$ est représenté schématiquement par un zigzag.

La section $S_{2,3}$ présente un coefficient $dneff_{2,3}/dT$ inférieur au coefficient $dneff_{2,1}/dT$, $dneff_{2,2}/dT$ et $dneff_{2,4}/dT$. Pour cela, selon une première solution, la section $S_{2,3}$ est un guide d'onde en silicium dont la largeur du cœur est inférieure à la largeur du cœur des sections $S_{2,1}$ et $S_{2,4}$. Selon une deuxième solution, la section $S_{2,3}$ est un guide d'onde dont le cœur est réalisé dans un matériau différent du silicium comme, par exemple, en nitrure de silicium. Dans ce cas, les dimensions du cœur de la section $S_{2,3}$ peuvent être identiques aux dimensions des cœurs en silicium des sections $S_{2,1}$ et $S_{2,4}$. Une troisième solution consiste à utiliser un autre matériau pour la gaine de la section $S_{2,3}$ différent de celui utilisé pour la gaine des sections $S_{2,1}$ et $S_{2,4}$. De plus, il est possible de combiner ces différentes solutions pour obtenir le coefficient $dneff_{2,3}/dT$ souhaité.

Pour que l'interféromètre 42 présente une bande passante qui permette de sélectionner la longueur d'onde $\lambda_{Li}$, les sections $S_{m,n}$ sont configurée pour vérifier la condition (1) suivante :

$$\sum_{n=1}^{N_2} L_{2,n}\, neff_{2,n} - \sum_{n=1}^{N_1} L_{1,n}\, neff_{1,n} = k_f\, \lambda_{Si}$$

où :

- $k_f$ est un nombre entier prédéterminé supérieur ou égal à 1,
- $N_1$ et $N_2$ sont les nombres de sections, respectivement, dans les bras 44, 46,
- $L_{1,n}$ et $L_{2,n}$ sont les longueurs des n-ièmes sections, respectivement, des bras 44, 46,
- $neff_{1,n}$ et $neff_{2,n}$ sont les indices effectifs des n-ièmes sections, respectivement, des bras 44, 46.

Un grand nombre de longueurs $L_{m,n}$ et d'indices $Neff_{m,n}$ permettent de satisfaire la condition (1).

Ici, le filtre 40 est également conçu pour être athermique. Ainsi son coefficient $d\lambda_{CF1}/dT$ est proche de zéro, c'est-à-dire compris compris entre $L_{min}$ et $L_{max}$. Par la suite, on note $\lambda_{CF1}$ une longueur d'onde correspondant à un maximum du spectre de transmission du filtre primaire 40. A cet effet, les sections $S_{m,n}$ sont configurés pour satisfaire également la condition (2) suivante :

$$L_{min} \leq \sum_{n=1}^{N_2} L_{2,n} \frac{d\, neff_{2,n}}{dT} - \sum_{n=1}^{N_1} L_{1,n} \frac{d\, neff_{1,n}}{dT} \leq L_{max}$$

où $dneff_{1,n}/dT$ et $dneff_{2,n}/dT$ sont les variations des indices effectifs des n-ièmes sections, respectivement, des bras 44 et 46.

Par exemple, ici, les longueurs $L_{m,n}$ et les coefficients $dneff_{m,n}/dT$ satisfont la condition (2) avec $L_{min}$ = -7 pm/°C et $L_{max}$ = +7 pm/°C et, de préférence, avec $L_{min}$ = -2 pm/°C et $L_{max}$ = +2 pm/°C.

Il existe un grand nombre de jeux de valeurs pour les longueurs $L_{m,n}$ et les indices $neff_{m,n}$ qui satisfont à la fois les conditions (1) et (2) ci-dessus. Ici, parmi l'ensemble de ces jeux, c'est le jeu de valeurs ou l'un des jeux de valeurs qui permet en plus d'obtenir une largeur $\Delta\lambda_{40}$ pour la bande passante du filtre primaire 40 supérieure à $\Delta\lambda_R$ qui est retenu.

Dans ces conditions, à cause du fait que l'interféromètre 42 satisfait la condition (2), la bande passante du filtre 22 ne se déplace pas ou pratiquement pas en fonction de la température. Par contre, dans ce mode de réalisation, les longueurs d'onde $\lambda_{Rj}$ se déplacent en fonction de la température. En particulier, la variation de la température peut être tel qu'une longueur d'onde $\lambda_{Rj}$ précédemment située à l'intérieur de la bande passante du filtre 22 se déplace et sort de cette bande passante. Dans ce cas, puisque la largeur $\Delta\lambda_{40}$ est égale ou supérieure à l'intervalle $\Delta\lambda_R$, lorsqu'une longueur d'onde $\lambda_{Rj}$ sort de la bande passante du filtre 22, une autre longueur d'onde $\lambda_{Rj-1}$ ou $\lambda_{Rj+1}$ rentre à l'intérieur de cette bande passante. Ainsi, dans ce mode de réalisation, il n'est pas nécessaire de mettre en œuvre un dispositif d'accord qui déplace les longueurs d'onde $\lambda_{Rj}$ de manière à ce qu'il existe en permanence une longueur d'onde $\lambda_{Rj}$ située au centre de la bande passante du filtre 22.

Pour configurer les sections $S_{m,n}$ de manière à ce qu'elles satisfassent les différentes conditions précédentes, une solution consiste, lors d'une première étape, à choisir les dimensions transversales de chaque section et les matériaux utilisés pour le cœur et la gaine de chaque section. Ainsi, les indices effectifs $neff_{m,n}$ et les coefficients $dneff_{m,n}/dT$ de chaque section sont déterminés. Ensuite, lors d'une seconde étape, les longueurs $L_{m,n}$ permettant de satisfaire les différentes conditions précédentes sont recherchées. S'il s'avère impossible de trouver des longueurs satisfaisantes, alors le procédé retourne à la première étape pour modifier les indices effectifs d'une ou plusieurs sections. Le dimensionnement de tels sections est par exemple réalisé en s'inspirant de l'enseignement donné, dans un contexte différent, dans l'article suivant : Biswajeet Guha et Al : « Minimizing temperature sensitivity of silicon Mach-Zehnder interferometers », Optics Express, 15/01/2010, pages 1879-1887.

La figure 2 représente la source laser 10 selon une coupe verticale passant par le bras 44. Sur cette figure, le trajet suivi par le signal optique entre les réflecteurs 12 et 14 est représenté par une flèche à double sens.

La source laser 10 comporte un substrat 70 qui s'étend principalement dans un plan horizontal appelé « plan du substrat ». L'épaisseur du substrat 70 est par exemple supérieure à 500 $\mu$m.

Une couche 72 de silicium monocristallin encapsulé dans de l'oxyde de silicium est empilée sur la face supérieure du substrat 70. Les réflecteurs 12 et 14, les guides d'onde 15 et 25 et les sections $S_{1,1}$, $S_{1,3}$, $S_{2,1}$, $S_{2,3}$ et $S_{2,4}$ ainsi que les parties inférieures des coupleurs 26, 32, 52 et 58 sont réalisés dans le silicium encapsulé de cette couche 72.

Une fine couche 74, par exemple en oxyde de silicium, est déposée sur la couche 72. Enfin, la source laser 10 comporte une couche 76 en matériau à gain encapsulé dans, par exemple, de l'oxyde de silicium. Les guides d'onde 28 et 54, les amplificateurs 30 et 56 et les parties supérieures des coupleurs 26, 32, 52 et 58 sont réalisés dans cette couche 76.

La figure 3 représente le spectre 80 de transmission du filtre primaire 40. L'axe des ordonnées représente le taux de transmission du filtre 40 et l'axe des abscisses la longueur d'onde associée à ce taux de transmission. Sur cette figure et les autres figures représentant un spectre de transmission, le taux de transmission du filtre est représenté en échelle logarithmique. Ainsi, un maximum du spectre de transmission correspond à la valeur 0 ou proche de la valeur 0 sur ces graphiques. Dans cet exemple, la largeur $\Delta\lambda_{40}$ d'une bande passante du filtre 40 est par exemple de 5 nm. Puisque cette largeur $\Delta\lambda_{40}$ est supérieure à l'intervalle $\Delta\lambda_R$, la source laser 10 est multimode.

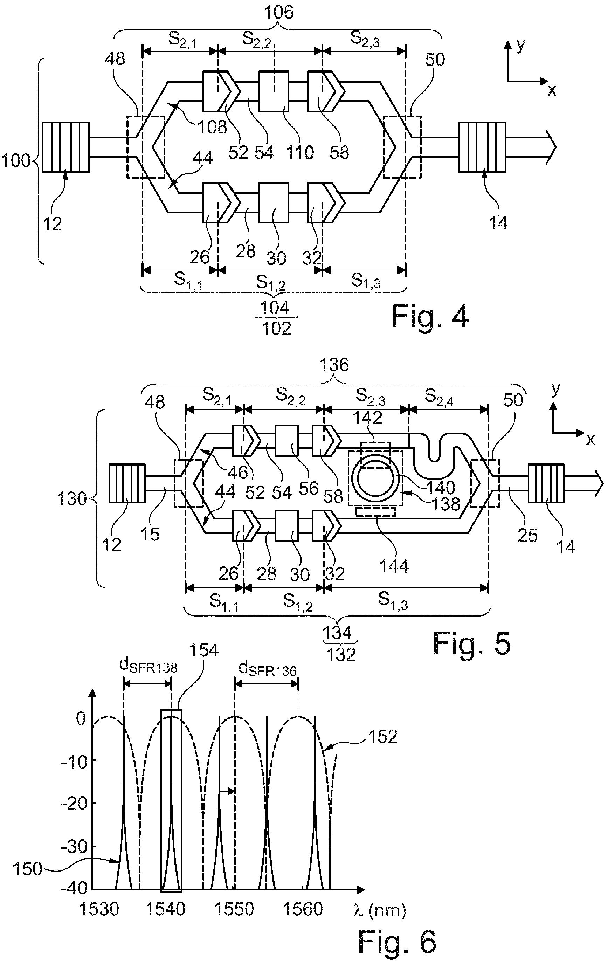

La figure 4 représente une source laser 100 identique à la source laser 10, sauf que le filtre 22 est remplacé par un filtre 102. Le filtre 102 est identique au filtre 22, sauf que le filtre primaire 40 est remplacé par un filtre primaire 104 qui comporte un interféromètre 106 à la place de l'interféromètre 42. L'interféromètre 106 est identique à l'interféromètre 42 sauf que le bras 46 est remplacé par un bras 108.

Le bras 108 est identique au bras 46 sauf qu'il comporte seulement trois sections $S_{2,1}$, $S_{2,2}$ et $S_{2,3}$. La section $S_{2,1}$ du bras 108 est identique à la section $S_{1,1}$ du bras 44. La section $S_{2,2}$ est identique à la section $S_{2,2}$ de l'interféromètre 42 sauf que l'amplificateur 56 est remplacé par un amplificateur 110 plus court que l'amplificateur 30. Ainsi, la longueur $L_{2,2}$ de la section $S_{2,2}$ du bras 108 est inférieure à la longueur $L_{1,2}$. La section $S_{2,3}$ est identique à la section $S_{1,3}$ sauf que la longueur $L_{2,3}$ est supérieure ou égale à la longueur $L_{1,3}$.

Comme dans le précédent mode de réalisation, les différentes sections $S_{m,n}$ sont agencées pour que les longueurs $L_{m,n}$ et les indices $neff_{m,n}$, satisfassent à la fois les conditions (1) et (2) précédemment décrites. Cette source laser 100 fonctionne comme la source laser 10 mais sans pour cela qu'il soit nécessaire d'implémenter une section supplémentaire dans l'un des bras dont l'indice effectif est inférieur aux indices $neff_{2,1}$ et $neff_{2,2}$.

La figure 5 représente une source laser 130 identique à la source laser 10, sauf que le filtre 22 est remplacé par un filtre 132 qui comporte un filtre primaire 134 à la place du filtre primaire 40. Le filtre 134 comporte un interféromètre 136 de Mach-Zehnder et un filtre secondaire 138.

Le filtre 138 est un filtre passe-bande comportant typiquement plusieurs bandes passantes. La largeur $\Delta\lambda_{138}$ de chacune de ces bandes passantes est inférieure ou égale à l'intervalle $\Delta\lambda_R$. Ici, la largeur $\Delta\lambda_{138}$ est égale à $\Delta\lambda_R$. Ce filtre 138 présente un coefficient $dneff_{138}/dT$ supérieur à zéro et généralement supérieur à 15 pm/°C ou 50 pm/°C, où $neff_{138}$ est l'indice effectif du guide d'onde dans lequel est réalisé le filtre 138. Ici, le filtre 138 est formé dans un guide d'onde en silicium. Ainsi, son coefficient $dneff_{138}/dT$ est supérieur à 50 pm/°C.

Dans ce mode de réalisation, le filtre 138 comporte un anneau résonnant 140. L'anneau 140 est couplé optiquement à la section $S_{2,3}$ du bras 46 par l'intermédiaire d'un couplage optique 142. Ainsi, une partie du signal optique qui traverse le bras 46 traverse également le filtre 138. Le couplage 142 est par exemple un couplage évanescent.

La figure 6 représente le spectre 150 de transmission du filtre 138. Ce spectre 150 comporte plusieurs bandes passantes régulièrement espacées les unes des autres par la distance $d_{FSR138}$. La figure 6 représente également le spectre 152 de transmission de l'interféromètre 136. Le spectre 152 présente plusieurs maximums de transmission régulièrement espacés les uns des autres par la distance $d_{FSR136}$.

Ici, le filtre 138 est agencé de manière à ce que la distance $d_{FSR138}$ est telle qu'à un instant donné, à l'intérieur de l'intervalle $\Delta R$, il ne peut exister qu'une seule bande passante du filtre 138 centrée sur un maximum de transmission du spectre 152. Pour cela soit le filtre 138 est configuré pour que la distance $d_{FSR138}$ soit supérieure $\Delta R$ soit le filtre 138 est configuré pour que la distance $d_{FSR138}$ soit un multiple non-entier de la distance $d_{FSR136}$ comme représenté sur la figure 6. Sur la figure 6, cette bande du filtre 138 centrée sur un maximum de transmission du spectre 152 est entourée par un rectangle 154. Dans ces conditions, le filtre 132 sélectionne une seule longueur d'onde $\lambda_{Li}$ contenue à l'intérieur de la bande passante entourée par le rectangle 154. La source laser 130 est donc une source laser monomode.

Ici, l'interféromètre 136 est identique à l'interféromètre 42 sauf que les différentes sections $S_{m,n}$ sont agencées de manière à vérifier la condition (1) et la condition (3) suivante :

$$L_{min} - \frac{d\,neff_{138}}{dT} \leq \sum_{n=1}^{N_2} L_{2,n} \frac{d\,neff_{2,n}}{dT} - \sum_{n=1}^{N_1} L_{1,n} \frac{d\,neff_{1,n}}{dT} \leq L_{max} - \frac{d\,neff_{138}}{dT}$$

Dans ce mode de réalisation, la condition (2) est remplacée par la condition (3) ci-dessus. Lorsque les conditions (1) et (3) sont satisfaites, l'interféromètre 136 compense une grande partie le déplacement du spectre de transmission du filtre 138 dû aux variations de température. Le filtre 134 qui combine cet interféromètre 136 et le filtre 138 est donc athermique. Le dimensionnement de tels sections est par exemple réalisé en s'inspirant de l'enseignement donné, dans un contexte différent, dans l'article suivant : Biswajeet Guha et Al : « CMOS-compatible athermal silicon microring resonators », Optics Express, 3/02/2010, pages 3487-3493.

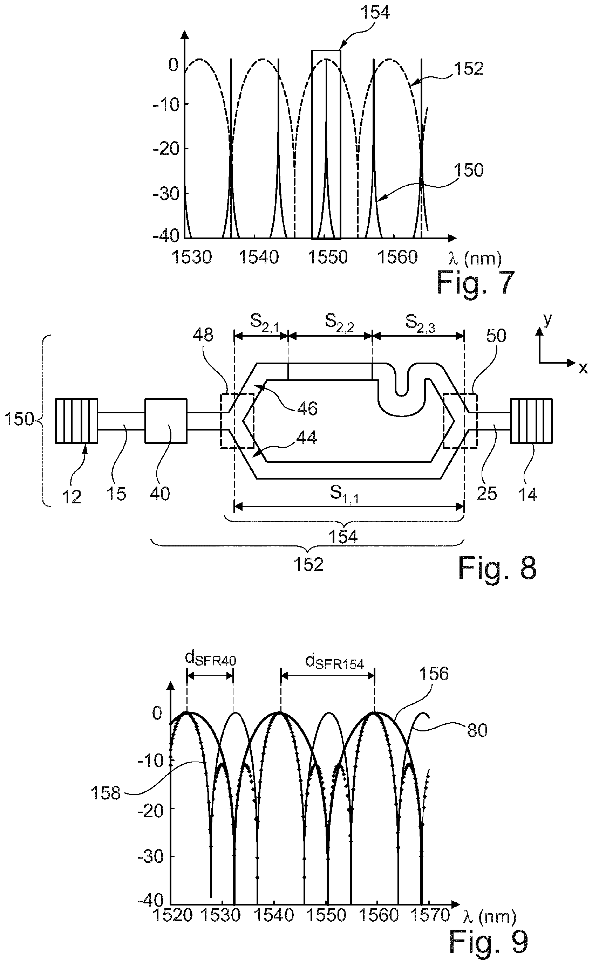

Ici, le filtre 134 comporte aussi un dispositif 144 de réglage de la position des bandes passantes du filtre 138 par rapport au maximum de transmission du spectre 152. Par exemple, le dispositif 144 est une chaufferette apte à chauffer localement l'anneau 140 sans chauffer les bras 44 et 46 de l'interféromètre 136. Comme illustré sur la figure 7, ce dispositif 144 permet de déplacer le spectre 150 par rapport au spectre 152 jusqu'à ce que ce soit une autre bande passante du filtre 138 qui soit centrée sur un maximum de transmission du spectre 152. Cela permet, avec un faible déplacement du spectre 150, de changer de façon importante la valeur de la longueur d'onde $\lambda_{Si}$ souhaitée de la source laser 130. Sur l'exemple des figures 6 et 7, un déplacement de moins de 4 nm du spectre 150 permet de faire varier la valeur de la longueur d'onde $\lambda_{Si}$ d'environ 10 nm.

La figure 8 représente une source laser 150 identique à la source laser 10, sauf que le filtre 22 est remplacé par un filtre 152 qui comporte en plus du filtre primaire 40, un filtre tertiaire 154 optiquement raccordé en série avec le filtre 40. Pour simplifier la figure 8, les détails du filtre 40 n'ont pas été représentés à nouveau.

Le filtre 154 est un filtre athermique dont le spectre 156 (figure 9) de transmission comporte plusieurs bandes passantes régulièrement espacées les unes des autres par une distance $d_{SFR154}$. De préférence, le filtre 154 est agencé pour que la distance $d_{SFR154}$ soit égale à $p.d_{SFR40}$, où p est un nombre entier supérieur ou égal à 2.

De plus, le filtre 154 est agencé pour qu'au moins un maximum de transmission de son spectre 156 soit confondu avec un maximum de transmission du spectre 80 du filtre 40. Dans ces conditions, la distance entre deux maximums consécutifs du spectre 158 de transmission (figure 9) du filtre 152 est égale à la distance $d_{SFR154}$. La largeur $\Delta\lambda_{152}$ de la bande passante du filtre 152 reste égale à la largeur $\Delta\lambda_{40}$ d'une bande passante du filtre 40. Ainsi, l'utilisation du filtre 154 permet d'espacer les bandes passantes du filtre 152 sans augmenter la largeur de ces bandes passantes. Cela permet donc de sélectionner un nombre de longueurs d'onde $\lambda_{Li}$ inférieur au nombre de longueurs d'onde $\lambda_{Li}$ sélectionné par le filtre 22 de la source laser 10. Grâce à cela, la source laser 150 peut être rendue monomode.

Ici, le filtre 154 est un interféromètre de Mach-Zehnder athermique. Par exemple, le filtre 154 est identique au filtre 40 sauf que :

- il est dépourvu de section à gain comportant un cœur en matériau à gain,
- les différentes sections sont ajustés pour vérifier les conditions (1) et (2) et en plus pour obtenir une distance $d_{SFR154}$ égale à p fois la distance $d_{SFR40}$.

Ainsi, le bras 44 du filtre 154 comporte une seule section $S_{1,1}$ entre les embranchements 48 et 50. Cette section $S_{1,1}$ est un guide d'onde dont le cœur est en silicium. Cette section $S_{1,1}$ est identique, par exemple, à la concaténation des sections $S_{1,1}$ et $S_{1,3}$ du filtre 40. Le bras 46 du filtre 154 comporte trois sections consécutives $S_{2,1}$, $S_{2,2}$ et $S_{2,3}$. Les sections $S_{2,1}$, $S_{2,2}$ et $S_{2,3}$ du filtre 154 sont par exemple identiques, respectivement, aux sections $S_{2,1}$, $S_{2,3}$ et $S_{2,4}$ du filtre 40.

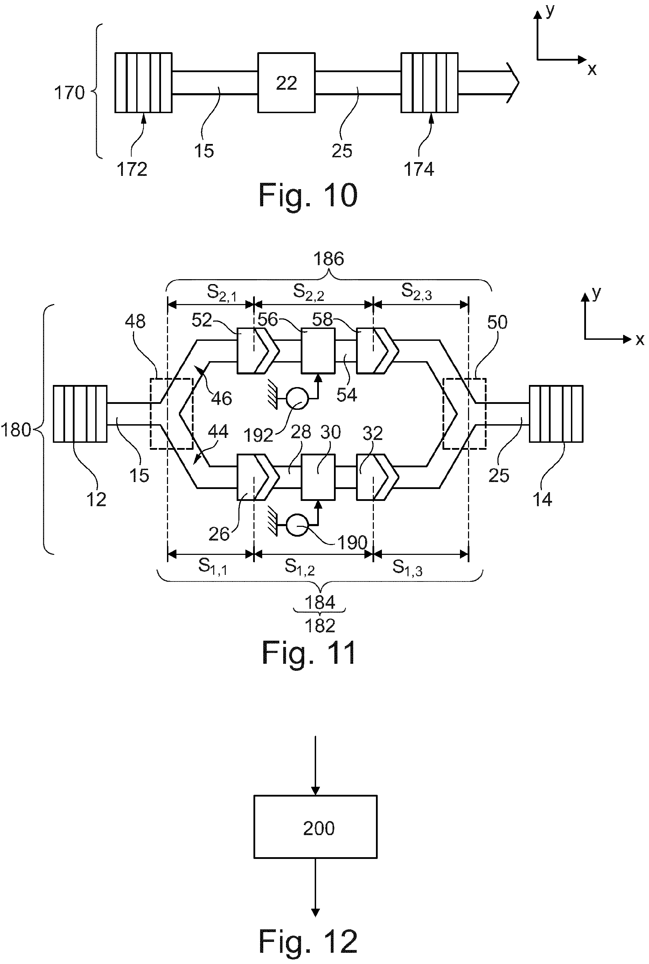

La figure 10 représente une source laser 170 identique à la source laser 10, sauf que les réflecteurs 12 et 14 sont remplacés, respectivement, par des réflecteurs 172 et 174. Les réflecteurs 172 et 174 sont des réflecteurs dont les bandes réfléchissantes sont étroites et plus étroites que les bandes réfléchissantes des réflecteurs 12 et 14. Ici, la largeur des bandes réfléchissantes des réflecteurs 172 et 174 est comprise entre $\Delta\lambda_R$ et $d_{SFR40}$. Ainsi, les réflecteurs 172 et 174 autorisent seulement des longueurs d'onde $\lambda_{Rj}$ contenues à l'intérieur d'une seule bande passante du filtre 22. Les réflecteurs 172 et 174 sont, par exemple, des réseaux de Bragg. La réalisation de tels réflecteurs à bande réfléchissante étroite est par exemple décrite dans l'article suivant : G. H. Duan et al. : « Hybrid III-V on Silicon Lasers for Photonic Integrated Circuits on Silicon », Journal of Selected Topics in Quantum Electronics, Vol. 20, n°4, 07/2014, pages 1-13.

De préférence, les réflecteurs 172 et 174 sont également peu sensibles aux variations de température. Par exemple, à cet effet, le cœur des réflecteurs 172 et 174 est réalisé dans un matériau à faible coefficient thermo-optique comme du nitrure de silicium.

La figure 11 représente une source laser 180 identique à la source laser 10, sauf que le filtre 22 est remplacé par un filtre 182 dans laquelle le filtre primaire 40 est remplacé par un filtre primaire 184. Le filtre 184 est identique au filtre 40 sauf que l'interféromètre 42 est remplacé par un interféromètre 186. L'interféromètre 186 est identique à l'interféromètre 42 sauf que le bras 46 est structurellement identique au bras 44. Ainsi, le bras 46 comporte seulement trois sections consécutives $S_{2,1}$, $S_{2,2}$ et S2,3. Ces sections $S_{2,1}$, $S_{2,2}$ et $S_{2,3}$ de l'interféromètre 186 sont identiques, respectivement, aux sections $S_{1,1}$, $S_{1,2}$ et $S_{1,3}$ du bras 44 de ce même interféromètre. Dans ces conditions, les longueurs totales des bras 44 et 46 sont égales. De plus, les dimensions transversales des cœurs des sections $S_{1,2}$ et $S_{2,2}$ sont identiques. Ici, par « dimensions transversales », on désigne les dimensions dans un plan orthogonal à la direction de propagation du signal optique. Il s'agit donc en particulier de la largeur et de la hauteur du cœur.

Par contre, dans ce mode de réalisation, les courants d'injection $I_1$ et $I_2$ qui traversent, respectivement, les amplificateurs 30 et 56 ne sont pas identiques. A cet effet, ici, les prises 37 des amplificateurs 30 et 56 sont électriquement raccordées à des sources d'alimentation respectives 190 et 192. Dans ces conditions, même si structurellement les sections $S_{1,2}$ et $S_{2,2}$ sont identiques, leurs indices effectifs $neff_{1,2}$ et $neff_{2,2}$ sont différents. En effet, puisque les intensités des courants $I_1$ et $I_2$ sont différentes, les températures des amplificateurs 30, 56 sont différentes et donc leurs indices effectifs sont différentes. Ici, les sources 190 et 192 sont réglées pour que la condition (1) soit satisfaite. Dans le cas particulier de la source laser 180, la condition (1) s'écrit alors sous la forme suivante :

$$L_{2,2}\,neff_{2,2} - L_{1,2}\,neff_{1,2} = k_f\,\lambda_{Si}$$

où les longueurs $L_{2,2}$ et $L_{1,2}$ sont égales.

Puisque les sections $S_{1,2}$ et $S_{2,2}$ sont structurellement identiques, les coefficients $dneff_{1,2}/dT$ et $dneff_{2,2}/dT$ sont égaux. Ainsi, la condition (2) précédemment décrite est aussi satisfaite dès que les longueurs $L_{2,2}$ et $L_{1,2}$ sont égales. Par conséquent, le filtre primaire 184 est également athermique. Le fonctionnement de la source laser 180 se déduit des explications données pour la source laser 10.

Plus précisément, comme représenté sur la figure 12, lors d'une étape 200 d'émission d'un signal optique à la longueur d'onde $\lambda_{Li}$ proche de la longueur d'onde $\lambda_{Si}$ souhaitée, les sources 190 et 192 injectent les courants $I_1$ et $I_2$ d'intensités différentes à travers, respectivement, les amplificateurs 30 et 56.

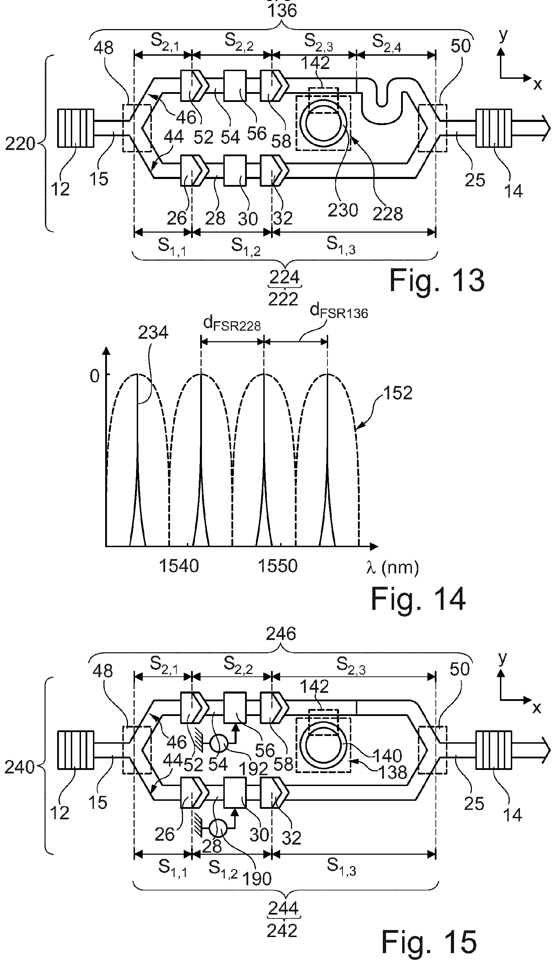

La figure 13 représente une source laser 220 identique à la source laser 130 sauf que le filtre passe-bande 132 est remplacé par un filtre passe-bande 222. Le filtre 222 est identique au filtre 132 sauf que le filtre primaire 134 est remplacé par un filtre primaire 224. Le filtre primaire 224 est identique au filtre primaire 134 sauf que le filtre secondaire 138 est remplacé par un filtre secondaire 228. Le filtre 228 est identique au filtre 138 sauf que l'anneau 140 est remplacé par un anneau 230. L'anneau 230 est configuré pour que:

- la largeur $\Delta\lambda_{228}$ de chaque bande passante du filtre 228 soit égale à $\Delta\lambda_R$,
- un maximum du spectre 234 (Figure 14) de transmission du filtre 228 coïncide avec un maximum du spectre 152 de transmission de l'interféromètre 136, et
- la distance $d_{FSR228}$ entre deux maximums consécutifs du spectre 234 (Figure 14) soit égale à $p.d_{SFR136}$, où p est un nombre entier.

La figure 14 représente les spectres 152 et 234 de transmission dans le cas particulier où p est égal à 1. Comme illustré sur cette figure 14, le filtre 222 sélectionne simultanément plusieurs longueurs d'ondes $\lambda_{Li}$ séparées les unes des autres par la distance $d_{FSR228}$. La source laser 220 est donc multimode.

La figure 15 représente une source laser 240 qui est une combinaison des modes de réalisation des figures 5 et 11. La source laser 240 est identique à la source laser 130 sauf que le filtre passe-bande 132 est remplacé par un filtre passe-bande 242. Le filtre 242 est identique au filtre 132 sauf que le filtre primaire 134 est remplacé par un filtre primaire 244. Le filtre primaire 244 est identique au filtre primaire 134 sauf que l'interféromètre 136 est remplacé par un interféromètre 246.

L'interféromètre 246 est identique à l'interféromètre 186 sauf que les longueurs $L_{1,2}$ et $L_{2,2}$ sont différentes. Comme précédemment décrit en référence à la figure 11, les intensités des courants continus $I_1$ et $I_2$ sont différentes. Ainsi, les indices effectifs $neff_{1,2}$ et $neff_{2,2}$ sont différents. Par contre les coefficients $dneff_{1,2}/dT$ et $dneff_{2,2}/dT$ sont égaux puisque les matériaux et la section transversale des cœurs des sections $S_{1,2}$ et $S_{2,2}$ sont identiques. Dans ce cas particulier, la condition (1) s'écrit alors sous la forme suivante :

$$L_{2,2} neff_{2,2} - L_{1,2} neff_{1,2} = k_f \lambda_{Si}$$

La condition (3) pour que le filtre primaire 244 soit athermique s'écrit sous la forme simplifiée suivante :

$$L_{min} - \frac{d\,neff_{138}}{dT} \leq L_{2,2} \frac{d\,neff_{2,2}}{dT} - L_{1,2} \frac{d\,neff_{1,2}}{dT} \leq L_{max} - \frac{d\,neff_{138}}{dT}$$

où les coefficient $dneff_{1,2}/dT$ et $dneff_{2,2}/dT$ sont égaux.

Pour trouver les intensités des courants $I_1$ et $I_2$ et les longueurs $L_{1,2}$ et $L2,2$ qui satisfont les conditions (1) et (3) précédentes, il est possible, par exemple, de fixer d'abord les intensités des courants $I_1$ et $I_2$ puis de rechercher les longueurs $L_{1,2}$ et $L_{2,2}$ qui satisfont les conditions précédentes. Il est aussi possible de procéder en sens inverse, c'est-à-dire que des longueurs $L_{1,2}$ et $L_{2,2}$ sont d'abord fixées puis les intensités des courants $I_1$ et $I_2$ sont recherchées.

Dans le mode de réalisation de la figure 15, le dispositif 144 d'accord est omis.

Chapitre III : variantes :

Variantes du filtre passe-bande :

En variante, la source laser comporte plusieurs filtres primaires raccordés en série les uns derrière les autres.

Dans un autre mode de réalisation, le filtre primaire n'est pas athermique. Dans ce cas, les différentes sections $S_{m,n}$ n'ont pas besoin d'être agencées pour vérifier la condition (2) ou (3). Si le filtre primaire n'est pas athermique et que ce filtre primaire est raccordé en série avec un filtre tertiaire, ce filtre tertiaire n'est pas lui non plus athermique. Plus précisément, dans ce cas, le filtre tertiaire est agencé pour que son coefficient $d\lambda_{CF3}/dT$ soit égal ou pratiquement égal au coefficient $d\lambda_{CF1}/dT$ du filtre primaire.

Le couplage optique 142 entre l'anneau 140 et le bras 46 peut être réalisé ailleurs. Par exemple, en variante, ce couplage optique est réalisé entre la section $S_{2,1}$ ou $S_{2,4}$ et l'anneau 140, voire même entre la section $S_{2,2}$ et l'anneau 140.

Un filtre tertiaire tel que le filtre 154 peut être implémenté dans les autres modes de réalisation décrits ici et, en particulier, dans les modes de réalisation des figures 1, 4, 5, 10, 11 et 13.

D'autres modes de réalisation du filtre tertiaire sont possibles. Par exemple, en variante, le filtre tertiaire est identique au filtre primaire 134 mais les sections $S_{1,2}$ et $S_{2,2}$ comportant des matériaux à gain sont omises. Dans un autre exemple de réalisation, le filtre tertiaire est rendu athermique non pas à l'aide d'un interféromètre de Mach-Zehnder mais par d'autres moyens. Par exemple, le cœur du filtre tertiaire est réalisé dans un matériau dont le coefficient thermo-optique est faible, c'est-à-dire au moins deux fois plus faible que le coefficient thermo-optique du silicium. Ainsi, dans un autre exemple, le filtre tertiaire est un anneau résonnant formé dans un guide d'onde en nitrure de silicium et couplé au guide d'onde 15 ou 25.

D'autres modes de réalisation du filtre secondaire 138 sont possibles. Plus précisément, tout autre filtre présentant un spectre de transmission similaire au spectre 150 et susceptible d'être couplé optiquement à l'une des sections du bras 46 peut être employé.

Le filtre secondaire peut aussi être réalisé dans des guides d'onde dont le cœur est réalisé dans un matériau dont le coefficient thermo-optique est faible. Par exemple, en variante, le filtre 138 est réalisé dans un guide d'onde dont le cœur est réalisé en nitrure de silicium et la gaine en oxyde de silicium.

Autres variantes :

Le fait d'injecter des courants $I_1$ et $I_2$ d'intensités différentes dans les amplificateurs 30 et 56 peut être mis en œuvre dans tous les modes de réalisation décrits ici. En particulier, des courants $I_1$ et $I_2$ d'intensités différentes peuvent être injectés à travers les amplificateurs 30 et 56 des modes de réalisation des figures 1, 4, 5, 8, 10 et 13. Dans ce cas, les autres sections des bras 44 et 46 sont agencées pour que les conditions (1) et (2) ou les conditions (1) et (3) soient vérifiées. Le fonctionnement de ces variantes est alors le même que celui de la source laser 180.

Dans la source laser 180, il n'est pas nécessaire que les sections $S_{1,1}$ et $S_{1,3}$ soient identiques, respectivement, aux sections $S_{2,1}$ et $S_{2,3}$. Par exemple, en variante la section $S_{1,1}$ est plus longue que la section $S_{2,1}$ et, en contre partie, la section $S_{1,3}$ est plus courte que la section $S_{2,3}$. En fait, il suffit que la condition (4) suivante soit vérifiée pour que la source laser 180 fonctionne correctement : $L_{1,1}neff_{1,1} + L_{1,3}neff_{1,3} = L_{2,1}neff2_{,1} + L_{2,3}neff_{2,3}$. Cette condition (4) se généralise sans difficulté au cas où chaque bras comporte plus de trois sections $S_{m,n}$.

Dans la source laser 180, s'il n'est pas nécessaire que le filtre passe-bande soit athermique, alors il n'est pas non plus nécessaire que les longueur $L_{1,2}$ et $L_{2,2}$ soient égales. Dans ce cas, la source laser 180 fonctionne correctement à partir du moment où les sections $S_{1,2}$ et $S_{2,2}$ sont configurées pour que la condition suivante soit vérifiée :

$$L_{2,2}neff_{2,2} - L_{1,2}neff_{1,2} = k_f \lambda_{Si}$$

La condition ci-dessus peut être satisfaite même avec des longueurs $L_{1,2}$ et $L_{2,2}$ différentes.

Le cœur des sections à gain telles que les sections $S_{1,2}$ et $S_{2,2}$ peut être réalisé en utilisant d'autres matériaux. Par exemple, l'empilement 34 peut aussi être un empilement de sous-couches en alternance en InP et InGaAsP. En variante, le matériau à gain est directement déposé sur un prolongement en silicium du guide d'onde 15 ou 25. Cette superposition du matériau à gain sur le prolongement en silicium forme alors le cœur d'un guide d'onde à gain optique. Dans ce cas, le guide d'onde à gain optique comporte du matériau III-V mais aussi du silicium.

Il existe aussi d'autres modes de réalisation de la cavité résonnante et, en particulier, des modes de réalisation dépourvus de réflecteur. Par exemple, la cavité peut prendre la forme d'un anneau dans lequel le signal optique tourne en traversant à chaque tour le matériau à gain de l'interféromètre. Par exemple, cela revient à remplacer les réflecteurs 12 et 14 par un guide d'onde supplémentaire qui raccorde l'extrémité gauche à l'extrémité droite de la cavité résonnante sans passer par l'intermédiaire des matériaux à gain. Dans ce cas, le guide d'onde supplémentaire est, par exemple, réalisé dans la couche 72.

Quel que soit le mode de réalisation décrit ici, pour limiter les conséquences du décalage de la bande réfléchissante des réflecteurs en fonction de la température, ces réflecteurs peuvent être réalisés dans un matériau à faible coefficient thermo-optique comme en nitrure de silicium.

Les réflecteurs ne sont pas nécessairement des réseaux de Bragg. Par exemple, un réflecteur peut également être réalisé à l'aide d'une boucle de Sagnac.

Enfin, le système permettant de limiter les variations de la longueur d'onde $\lambda_{Li}$ en fonction de la température n'est pas nécessairement un système passif comme décrit dans les précédents modes de réalisation. Ainsi, en variante, la source laser peut comporter :

- un dispositif d'accord apte à déplacer les longueurs d'onde $\lambda_{Rj}$ en fonction d'un signal électrique de commande,
- un capteur apte à mesurer une grandeur physique représentative de l'écart entre la longueur d'onde $\lambda_{Cf}$ du filtre passe-bande et la plus proche des longueurs d'onde $\lambda_{Rj}$, et
- un circuit électronique apte à générer le signal électrique de commande de manière à maintenir en permanence une des longueurs d'onde $\lambda_{Rj}$ au centre de la bande passante du filtre passe-bande.

La longueur d'onde $\lambda_{Cf}$ du filtre passe-bande correspond à un maximum du spectre de transmission de ce filtre. Des modes de réalisation et d'implémentation de ces différents composants dans une source laser sont, par exemple, identiques à ceux décrits dans la demande US20180261976A.

Chapitre IV : Avantages des modes de réalisation :

Le fait de réaliser le guide d'onde à gain dans chacun des bras d'un l'interféromètre permet de diminuer de façon substantielle la longueur de la cavité résonnante par rapport au cas d'une cavité résonnante permettant de générer un signal optique identique et de même puissance, mais dans laquelle le guide d'onde à gain est situé en dehors du filtre passe-bande. En effet, ici, les fonctions de filtrage et d'amplification du signal optique sont imbriquées et réalisées par un même composant à savoir un interféromètre de Mach-Zehnder. Ainsi, à caractéristique égale et, en particulier à puissance égale, la cavité résonnante des sources lasers décrites ici est beaucoup plus courte. Cela permet donc, à caractéristique égale, de réduire l'encombrement de la source laser.

Le fait d'utiliser un interféromètre de Mach-Zehnder agencé de manière à satisfaire la condition (2) ou (3) permet de limiter le déplacement de la bande passante de ce filtre en fonction de la température. Ceci limite les variations de la longueur d'onde $\lambda_{Li}$ en fonction de la température. En particulier, cette limitation est obtenue sans qu'il soit nécessaire pour cela de réaliser une partie de ce filtre passe-bande dans des matériaux à faible coefficient thermo-optique comme le nitrure de silicium. La réalisation de ce filtre passe-bande est donc plus simple. De plus, la limitation du déplacement de la bande passante du filtre en fonction de la température qui peut être obtenue est meilleure que celle qu'il est possible d'obtenir en réalisant, au moins en partie, le filtre passe-bande dans des matériaux à faible coefficient thermo-optique.

Lorsque les bras de l'interféromètre ne comportent aucun couplage optique avec un filtre secondaire tel que le filtre 138 et que cet interféromètre est agencé pour vérifier la condition (2), son spectre de transmission varie très peu en fonction de la température. Par conséquent, la position de la bande passante de son spectre de transmission est pratiquement constante. Grâce à cela, il est possible de limiter les variations de la longueur d'onde $\lambda_{Li}$ de la source laser en fonction de la température.

Lorsque le bras de l'interféromètre comporte un couplage optique avec un filtre secondaire tel que le filtre 138 et que cet interféromètre est agencé pour satisfaire la condition (3), le filtre primaire obtenu est aussi athermique. Ainsi, ce mode de réalisation du filtre passe-bande permet lui aussi de limiter les variations de la longueur d'onde $\lambda_{Li}$ en fonction de la température. De plus, le filtre secondaire permet de réduire la largeur de la ou des bandes passantes du filtre passe-bande ou de limiter certaines bandes passantes par rapport au cas où ce filtre passe-bande serait dépourvu d'un tel filtre secondaire. Cela permet donc d'obtenir une source laser monomode.

Le fait que le filtre secondaire soit un anneau résonnant permet de diminuer l'encombrement de la source laser.

L'utilisation d'un filtre tertiaire athermique raccordé en série avec le filtre primaire permet d'espacer les bandes passantes du filtre passe-bande tout en conservant de faibles variations de la longueur d'onde $\lambda_{Li}$ en fonction de la température.

L'utilisation d'un interféromètre de Mach-Zehnder athermique pour réaliser le filtre tertiaire permet d'obtenir un filtre tertiaire dont le spectre varie très peu en fonction de la température et donc de limiter de façon très efficace les variations de la longueur d'onde $\lambda_{Li}$ en fonction de la température.

Le fait que la largeur de la bande passante du filtre passe-bande soit inférieure ou égale à l'intervalle $\Delta\lambda_R$ permet d'obtenir une source laser monomode. A l'inverse, le fait que la largeur de la bande passante du filtre passe-bande soit supérieure à l'intervalle $\Delta\lambda_R$ permet d'obtenir une source laser multimode.

L'utilisation de réflecteurs dont la bande réfléchissante est étroite permet d'obtenir une source laser monomode.

La présence dans le spectre de transmission du filtre passe-bande de plusieurs bandes passantes espacées les unes des autres par un intervalle égal à un multiple entier de l'intervalle $\Delta\lambda_R$ permet d'obtenir une source laser multimode.

Le fait que la bande passante du filtre passe-bande ait une largeur sensiblement identique à l'intervalle $\Delta\lambda_R$ permet d'obtenir une stabilisation thermique passive de la longueur d'onde $\lambda_{Li}$ En effet, si suite à un échauffement de la cavité résonnante, la longueur d'onde $\lambda_{Rj}$ sélectionnée par le filtre passe-bande se déplace et sort de cette bande passante, dans le même temps, la longueur d'onde précédente $\lambda_{Rj-1}$ ou la longueur d'onde suivante $\lambda_{Rj+1}$ rentre à l'intérieur de cette bande passante. Ainsi, même en l'absence de composant actif pour maintenir l'une des longueurs d'onde $\lambda_{Rj}$ au centre de la bande passante du filtre passe-bande, les variations de la longueur d'onde $\lambda_{Li}$ en fonction de la température sont limitées.

Avantages des courants $I_1$ et $I_2$ d'intensités différentes :

Le fait d'injecter des courants $I_1$ et $I_2$ d'intensités différentes dans les amplificateurs 30 et 56 permet d'obtenir des sections $S_{1,2}$ et $S_{2,2}$ dont les indices effectifs sont différents sans pour cela avoir à jouer sur les dimensions transversales de ces sections ou sur les matériaux qui les composent. Cela simplifie donc la réalisation du filtre passe-bande.

Si, en plus, les bras 44 et 46 sont structurellement identiques et que ces bras ne sont pas couplés à un filtre secondaire, alors le simple fait de vérifier la condition (1) entraîne nécessairement le fait que la condition (2) est vérifiée. Cela facilite donc la réalisation d'un filtre primaire qui est en plus athermique.

**Revendications**

**1.** Source laser à semi-conducteur apte à émettre à une longueur d'onde $\lambda_{Li}$ proche d'une longueur d'onde $\lambda_{Si}$ souhaitée,cette source laser comportant :

- un ensemble de guides d'onde (15, 25, 28, 54) optiquement couplés les uns aux autres et formant une cavité optique apte à faire résonner un signal optique à plusieurs fréquences de résonance possibles, les longueurs d'onde possibles $\lambda_{Rj}$ de ces fréquences de résonance possibles étant régulièrement espacées les unes des autres par un intervalle $\Delta\lambda_R$, cet ensemble comportant :

• au moins un guide d'onde dans lequel est réalisé un filtre passe-bande (182 ; 242), le spectre de transmission de ce filtre passe-bande comportant une bande passante apte à sélectionner, parmi les différentes longueurs d'onde $\lambda_{Rj}$ possibles, la longueur d'onde $\lambda_{Li}$ la plus proche de la longueur d'onde $\lambda_{Si}$, et
• au moins un guide d'onde (28, 54) à gain apte à générer du gain optique à chaque longueur d'onde $\lambda_{Li}$ sélectionnée par le filtre passe-bande, ce guide d'onde à gain comportant un matériau à gain III-V,

dans lequel :

- le filtre passe-bande (182 ; 242) comporte un filtre primaire (184 ; 244) contenant un interféromètre de Mach-Zehnder (186 ; 246), cet interféromètre comportant :

  • un premier et un second bras (44, 46),
  • un premier embranchement (48) au niveau duquel le signal optique est réparti entre le premier et le second bras, et
  • un second embranchement (50) au niveau duquel les signaux optiques du premier et du second bras sont combinés ensemble,

- chacun du premier et second bras étant divisés en plusieurs sections consécutives ($S_{m,n}$) immédiatement contiguës les unes aux autres, chaque section comportant un cœur apte à guider le signal optique et chaque section présentant un indice effectif à la longueur d'onde $\lambda_{Si}$, l'indice effectif de chaque section située immédiatement après une section précédente étant différent de l'indice effectif de cette section précédente,
- les indices effectifs à la longueur d'onde $\lambda_{Si}$ des différentes sections des premier et second bras étant tels que la première relation suivante est vérifiée lors de l'émission du signal optique :

$$\sum_{n=1}^{N_2} L_{2,n}\, neff_{2,n} - \sum_{n=1}^{N_1} L_{1,n}\, neff_{1,n} = k_f\, \lambda_{Si}$$

où :

- $k_f$ est un nombre entier prédéterminé supérieur ou égal à 1,
- $N_1$ et $N_2$ sont les nombres de sections, respectivement, dans les premier et second bras,
- $L_{1,n}$ et $L_{2,n}$ sont les longueurs des n-ièmes sections, respectivement, des premier et second bras,
- $neff_{1,n}$ et $neff_{2,n}$ sont les indices effectifs des n-ièmes sections, respectivement, des premier et second bras,

**caractérisé en ce que** :

- les premier et second bras comportent chacun une section à gain ($S_{1,2}$, $S_{2,2}$), les cœurs de chacune de ces sections à gain étant réalisés à partir du même matériau à gain III-V et les dimensions transversales des cœurs de ces sections à gain étant identiques, ces sections à gain formant ainsi, respectivement, un premier et un second guides d'onde à gain,
- la source laser comporte des sources (190, 192) d'alimentation aptes, lors de l'émission du signal optique, à injecter des premier et second courants continus à travers, respectivement, les premier et second guides d'onde à gain, les intensités de ces premier et second courants continus étant constantes et différentes et telles que la première condition est vérifiée lors de l'émission du signal optique, les indices effectifs des sections à gain ($S_{1,2}$, $S_{2,2}$) étant fonction des intensités des premier et second courants continus.

2. Source selon la revendication 1, dans laquelle :

- le filtre primaire (244) comporte un filtre secondaire (138) dont le spectre de transmission comporte une bande passante étroite située à l'intérieur d'une bande passante plus large de l'interféromètre, ce filtre secondaire présentant un coefficient $d\lambda_{CF2}/dT$ supérieur à $L_{max}$, où :

  • $\lambda_{CF2}$ est la longueur d'onde correspondant à un maximum du spectre de transmission du filtre secondaire,
  • le coefficient $d\lambda_{CF2}dT$ est la variation de la longueur d'onde $\lambda_{CF2}$ en fonction de la température, et
  • $L_{max}$ est égal à 50 pm/°C ou 15 pm/°C,

- l'un des premier et second bras de l'interféromètre comporte un couplage optique (142) avec le filtre secondaire, et
- les longueurs des différentes sections des premier et second bras sont telles qu'un coefficient $d\lambda_{CMZI}/dT$ est compris entre $-d\lambda_{CF2}/dT + L_{min}$ et $-d\lambda_{CF2}/dT + L_{max}$, où :

- $\lambda_{CMZI}$ est une longueur d'onde correspondant à un maximum du spectre de transmission de l'interféromètre,
- le coefficient $d\lambda_{CMZI}/dT$ est la variation de la longueur d'onde $\lambda_{CMZI}$ en fonction de la température,
- $L_{min}$ est égale à -50 pm/°C ou -15 pm/°C, et
- $L_{max}$ est égale à +50 pm/°C ou +15 pm/°C.

**3.** Source selon la revendication 2, dans laquelle le filtre secondaire comporte un anneau résonnant (140) optiquement couplé à l'un des premier et second bras de l'interféromètre (246), la bande passante étroite du spectre de transmission de cet anneau résonnant étant centrée sur la longueur d'onde $\lambda_{CMZI}$ et ayant une largeur $\Delta\lambda_{F2}$ inférieure ou égale à l'intervalle $\Delta\lambda_R$.

**4.** Source selon la revendication 1, dans laquelle :

- aucun des bras de l'interféromètre ne comporte un couplage optique avec un filtre secondaire,
- les longueurs des différentes sections des premier et second bras sont telles qu'un coefficient $d\lambda_{CMZI}/dT$ est compris entre $L_{min}$ et $L_{max}$ sur une plage de températures allant de 20° à 100°, où :

- $\lambda_{CMZI}$ est une longueur d'onde correspondant à un maximum du spectre de transmission de l'interféromètre,
- le coefficient $d\lambda_{CMZI}/dT$ est la variation de la longueur d'onde $\lambda_{CMZI}$ en fonction de la température,
- $L_{min}$ est égale à -50 pm/°C ou -15 pm/°C, et
- $L_{max}$ est égale à +50 pm/°C ou +15 pm/°C.

**5.** Source selon la revendication 4, dans laquelle les longueurs des sections des premier et second bras vérifient la condition d'athermicité suivante pour la longueur d'onde $\lambda_{Si}$ et sur une plage de températures allant de 20° à 100°C :

$$L_{min} \le \sum_{n=1}^{N_2} L_{2,n} \frac{d\,neff_{2,n}}{dT} - \sum_{n=1}^{N_1} L_{1,n} \frac{d\,neff_{1,n}}{dT} \le L_{max}$$

où $dneff_{1,n}/dT$ et $dneff_{2,n}/dT$ sont les variations des indices effectifs des n-ièmes sections, respectivement, des premier et second bras.

**6.** Source selon l'une quelconque des revendications 4 à 5, dans laquelle les premier et second bras (44, 46) sont structurellement identiques.

**7.** Source selon l'une quelconque des revendications précédentes, dans laquelle :

- le filtre passe-bande (152) comporte un filtre tertiaire (154) optiquement raccordé en série avec le filtre primaire, le spectre de transmission de ce filtre tertiaire comportant plusieurs bandes passantes espacées les unes des autres par une distance $d_{SFR154}$ au moins deux fois plus grande qu'une distance $d_{SFR40}$, où la distance $d_{SFR40}$ est la distance qui sépare les unes des autres les bandes passantes du spectre de transmission de l'interféromètre (186 ; 246) du filtre primaire,
- ce filtre tertiaire (154) présente un coefficient $d\lambda_{CF3}/dT$ compris entre $L_{min}$ et $L_{max}$, où :

- $\lambda_{CF3}$ est une longueur d'onde correspondant à un maximum du spectre de transmission du filtre tertiaire,
- le coefficient $d\lambda_{CF3}/dT$ est la variation de la longueur d'onde $\lambda_{CF3}$ en fonction de la température,
- $L_{min}$ est égale à -50 pm/°C ou -15 pm/°C, et
- $L_{max}$ est égale à +50 pm/°C ou +15 pm/°C.

**8.** Source selon la revendication 2 ou 7, dans laquelle :

- les bandes passantes du filtre secondaire (138) ou tertiaire (154) sont séparées les unes des autres par une distance telle qu'il n'existe, à l'intérieur d'un intervalle $\Delta R$, qu'une seule bande passante du filtre secondaire ou tertiaire centrée sur un maximum de transmission du spectre de transmission de l'interféromètre du filtre primaire, où l'intervalle $\Delta R$ est la plus petite plage de longueurs d'onde contenant toutes les longueurs d'onde $\lambda_{Rj}$ possibles autorisées par la cavité résonnante, et

- la largeur de la bande passante du filtre secondaire ou tertiaire centrée sur le maximum de transmission du spectre de transmission de l'interféromètre du filtre primaire est inférieure ou égale à l'intervalle $\Delta\lambda_R$.

9. Source selon la revendication 2 ou 7, dans laquelle :

- les bandes passantes du filtre secondaire (228) ou tertiaire (154) sont séparées les unes des autres par une distance égale à un multiple entier de l'intervalle $\Delta\lambda_R$ et inférieur à un intervalle $\Delta R$, où l'intervalle $\Delta R$ est la plus petite plage de longueurs d'onde contenant toutes les longueurs d'onde $\lambda_{Rj}$ possibles autorisées par la cavité résonnante, et
- une bande passante du filtre secondaire ou tertiaire est centrée sur un maximum de transmission du spectre de transmission de l'interféromètre du filtre primaire.

10. Procédé d'émission d'un signal optique à une longueur d'onde $\lambda_{Li}$ proche d'une longueur d'onde $\lambda_{Si}$ souhaitée, ce procédé comportant :

a) la fourniture d'une source laser comportant :

- un ensemble de guides d'onde (15, 25, 28, 54) optiquement couplés les uns aux autres et formant une cavité optique apte à faire résonner un signal optique à plusieurs fréquences de résonance possibles, les longueurs d'onde possibles $\lambda_{Rj}$ de ces fréquences de résonance possibles étant régulièrement espacées les unes des autres par un intervalle $\Delta\lambda_R$, cet ensemble comportant :

   • au moins un guide d'onde dans lequel est réalisé un filtre passe-bande (182 ; 242), le spectre de transmission de ce filtre passe-bande comportant une bande passante apte à sélectionner, parmi les différentes longueurs d'onde $\lambda_{Rj}$ possibles, la longueur d'onde $\lambda_{Li}$ la plus proche de la longueur d'onde $\lambda_{Si}$, et
   • au moins un guide d'onde (28, 54) à gain apte à générer du gain optique à chaque longueur d'onde $\lambda_{Li}$ sélectionnée par le filtre passe-bande, ce guide d'onde à gain comportant un matériau à gain III-V, dans lequel :

- le filtre passe-bande (182 ; 242) comporte un filtre primaire (184 ; 244) contenant un interféromètre de Mach-Zehnder (186, 246), cet interféromètre comportant :

   • un premier et un second bras (44, 46),
   • un premier embranchement (48) au niveau duquel le signal optique est réparti entre le premier et le second bras, et
   • un second embranchement (50) au niveau duquel les signaux optiques du premier et du second bras sont combinés ensemble,

- chacun du premier et second bras étant divisés en plusieurs sections consécutives ($S_{m,n}$) immédiatement contiguës les unes aux autres, chaque section comportant un cœur apte à guider le signal optique et chaque section présentant un indice effectif à la longueur d'onde $\lambda_{Si}$, l'indice effectif de chaque section située immédiatement après une section précédente étant différent de l'indice effectif de cette section précédente,
- les premier et second bras comportent chacun une section à gain ($S_{1,2}$, $S_{2,2}$), les cœurs de chacune de ces sections à gain étant réalisés à partir du même matériau à gain III-V et les dimensions transversales des cœurs de ces sections à gain étant identiques, ces sections à gain formant ainsi, respectivement, un premier et un second guides d'onde à gain,

b) lors de l'émission du signal optique, un premier et un second courants continus sont injectés (200) à travers, respectivement, les premier et second guides d'onde à gain, les intensités de ces premier et second courants étant constantes et différentes et telles que la condition suivante est vérifiée :

$$\sum_{n=1}^{N_2} L_{2,n}\, neff_{2,n} - \sum_{n=1}^{N_1} L_{1,n}\, neff_{1,n} = k_f\, \lambda_{Si}$$

où :

- $k_f$ est un nombre entier prédéterminé supérieur ou égal à 1,
- $N_1$ et $N_2$ sont les nombres de sections, respectivement, dans les premier et second bras,
- $L_{1,n}$ et $L_{2,n}$ sont les longueurs des n-ièmes sections, respectivement, des premier et second bras,
- $neff_{1,n}$ et $neff_{2,n}$ sont les indices effectifs des n-ièmes sections, respectivement, des premier et second bras, les indices effectifs des sections à gain ($S_{1,2}$, $S_{2,2}$) étant fonction des intensités des premier et second courants continus.

## Patentansprüche

1. Halbleiter-Laserquelle, welche in der Lage ist, mit einer Wellenlänge $\lambda_{Li}$ zu emittieren, die einer gewünschten Wellenlänge $\lambda_{Si}$ nahekommt, wobei diese Laserquelle aufweist:

    - eine Anordnung von Wellenleitern (15, 25, 28, 54), die optisch miteinander gekoppelt sind und einen optischen Resonator bilden, der in der Lage ist, ein optisches Signal mit mehreren möglichen Resonanzfrequenzen mitschwingen zu lassen, wobei die möglichen Wellenlängen $\lambda_{Rj}$ dieser möglichen Resonanzfrequenzen um ein Intervall $\Delta\lambda_R$ gleichmäßig voneinander beabstandet sind, wobei diese Anordnung aufweist:

        • wenigstens einen Wellenleiter, in welchem ein Bandpassfilter (182; 242) realisiert ist, wobei das Übertragungsspektrum dieses Bandpassfilters ein Durchlassband aufweist, das in der Lage ist, aus den verschiedenen möglichen Wellenlängen $\lambda_{Rj}$ die Wellenlänge $\lambda_{Li}$ auszuwählen, die der Wellenlänge $\lambda_{Si}$ am nächsten kommt, und
        • wenigstens einen Verstärkungswellenleiter (28, 54), der in der Lage ist, bei jeder durch das Bandpassfilter ausgewählten Wellenlänge $\lambda_{Li}$ eine optische Verstärkung zu erzeugen, wobei dieser Verstärkungswellenleiter ein Verstärkungsmaterial III-V enthält,

    wobei:

        - das Bandpassfilter (182; 242) ein primäres Filter (184; 244) aufweist, das ein Mach-Zehnder-Interferometer (186, 246) enthält, wobei dieses Interferometer aufweist:

            • einen ersten und einen zweiten Arm (44, 46),
            • eine erste Verzweigung (48), an welcher das optische Signal zwischen dem ersten und dem zweiten Arm aufgeteilt wird, und
            • eine zweite Verzweigung (50), an welcher die optischen Signale des ersten und des zweiten Armes miteinander kombiniert werden,

    - wobei der erste und der zweite Arm jeweils in mehrere aufeinander folgende Abschnitte ($S_{m,n}$) unterteilt sind, die unmittelbar aneinander angrenzen, wobei jeder Abschnitt einen Kern umfasst, der in der Lage ist, das optische Signal zu leiten, und jeder Abschnitt einen effektiven Index bei der Wellenlänge $\lambda_{Si}$ aufweist, wobei der effektive Index jedes Abschnitts, der sich unmittelbar nach einem vorangegangenen Abschnitt befindet, vom effektiven Index dieses vorangegangenen Abschnitts verschieden ist,
    - wobei die effektiven Indizes bei der Wellenlänge $\lambda_{Si}$ der verschiedenen Abschnitte des ersten und des zweiten Armes so bemessen sind, dass die folgende erste Beziehung während der Emission des optischen Signals erfüllt ist:

$$\sum_{n=1}^{N_2} L_{2,n}\, neff_{2,n} - \sum_{n=1}^{N_1} L_{1,n}\, neff_{1,n} = k_f\, \lambda_{Si}$$

    wobei:

        - $k_f$ eine vorbestimmte ganze Zahl größer oder gleich 1 ist,
        - $N_1$ und $N_2$ die Anzahlen der Abschnitte im ersten bzw. zweiten Arm sind,
        - $L_{1,n}$ und $L_{2,n}$ die Längen der n-ten Abschnitte des ersten bzw. zweiten Armes sind,

- neff$_{1,n}$ und neff$_{2,n}$ die effektiven Indizes der n-ten Abschnitte des ersten bzw. zweiten Armes sind,

**dadurch gekennzeichnet, dass**:

- der erste und der zweite Arm jeweils einen Verstärkungsabschnitt (S$_{1,2}$, S$_{2,2}$) aufweisen, wobei die Kerne aller dieser Verstärkungsabschnitte aus demselben Verstärkungsmaterial III-V hergestellt sind und die Querabmessungen der Kerne dieser Verstärkungsabschnitte identisch sind, wobei diese Verstärkungsabschnitte somit einen ersten bzw. einen zweiten Verstärkungswellenleiter bilden,
- die Laserquelle Versorgungsquellen (190, 192) aufweist, die in der Lage sind, während der Emission des optischen Signals einen ersten und einen zweiten Gleichstrom durch den ersten bzw. zweiten Verstärkungswellenleiter zu injizieren, wobei die Stromstärken dieses ersten und zweiten Gleichstroms konstant und verschieden und so bemessen sind, dass die erste Bedingung während der Emission des optischen Signals erfüllt ist, wobei die effektiven Indizes der Verstärkungsabschnitte (S$_{1,2}$, S$_{2,2}$) von den Stromstärken des ersten und zweiten Gleichstroms abhängen.

2. Quelle nach Anspruch 1, wobei:

- das primäre Filter (244) ein sekundäres Filter (138) umfasst, dessen Übertragungsspektrum ein schmales Durchlassband aufweist, das sich im Inneren eines breiteren Durchlassbandes des Interferometers befindet, wobei dieses sekundäre Filter einen Koeffizienten d$\lambda_{CF2}$/dT aufweist, der größer als L$_{max}$ ist, wobei:

  • $\lambda_{CF2}$ die Wellenlänge ist, die einem Maximum des Übertragungsspektrums des sekundären Filters entspricht,
  • der Koeffizient d$\lambda_{CF2}$/dT die Änderung der Wellenlänge $\lambda_{CF2}$ in Abhängigkeit von der Temperatur ist und
  • L$_{max}$ gleich 50 pm/°C oder 15 pm/°C ist,

- einer von dem ersten und dem zweiten Arm des Interferometers eine optische Kopplung (142) mit dem sekundären Filter aufweist, und
- die Längen der verschiedenen Abschnitte des ersten und des zweiten Armes so bemessen sind, dass ein Koeffizient d$\lambda_{CMZI}$/dT zwischen -d$\lambda_{CF2}$/dT + L$_{min}$ und -d$\lambda_{CF2}$/dT + L$_{max}$ liegt, wobei:

  • $\lambda_{CMZI}$ die Wellenlänge ist, die einem Maximum des Übertragungsspektrums des Interferometers entspricht,
  • der Koeffizient d$\lambda_{CMZI}$/dT die Änderung der Wellenlänge $\lambda_{CMZI}$ in Abhängigkeit von der Temperatur ist,
  • L$_{min}$ gleich -50 pm/°C oder -15 pm/°C ist und
  • L$_{max}$ gleich +50 pm/°C oder +15 pm/°C ist.

3. Quelle nach Anspruch 2, wobei das sekundäre Filter einen Ringresonator (140) aufweist, der mit einem von dem ersten und dem zweiten Arm des Interferometers (246) optisch gekoppelt ist, wobei das schmale Durchlassband des Übertragungsspektrums dieses Ringresonators um die Wellenlänge $\lambda_{CMZI}$ zentriert ist und eine Breite $\Delta\lambda_{F2}$ aufweist, die kleiner oder gleich dem Intervall $\Delta\lambda_R$ ist.

4. Quelle nach Anspruch 1, wobei:

- keiner der Arme des Interferometers eine optische Kopplung mit einem Interferometer aufweist,
- die Längen der verschiedenen Abschnitte des ersten und des zweiten Armes so bemessen sind, dass ein Koeffizient d$\lambda_{CMZI}$/dT in einem Temperaturbereich von 20° bis 100° zwischen L$_{min}$ und L$_{max}$ liegt, wobei:

  • $\lambda_{CMZI}$ die Wellenlänge ist, die einem Maximum des Übertragungsspektrums des Interferometers entspricht,
  • der Koeffizient d$\lambda_{CMZI}$/dT die Änderung der Wellenlänge $\lambda_{CMZI}$ in Abhängigkeit von der Temperatur ist,
  • L$_{min}$ gleich -50 pm/°C oder -15 pm/°C ist und
  • L$_{max}$ gleich +50 pm/°C oder +15 pm/°C ist.

5. Quelle nach Anspruch 4, wobei die Längen der Abschnitte des ersten und des zweiten Armes für die Wellenlänge $\lambda_{Si}$ und in einem Temperaturbereich von 20° bis 100°C die folgende Bedingung der Athermizität erfüllen:

$$L_{min} \le \sum_{n=1}^{N_2} L_{2,n} \frac{d\ neff_{2,n}}{dT} - \sum_{n=1}^{N_1} L_{1,n} \frac{d\ neff_{1,n}}{dT} \text{¿} L_{max}$$

wobei $dneff_{1,n}/dT$ und $dneff_{2,n}/dT$ die Änderungen der effektiven Indizes der n-ten Abschnitte des ersten bzw. zweiten Armes sind.

6. Quelle nach einem der Ansprüche 4 bis 5, wobei der erste und der zweite Arm (44, 46) strukturell identisch sind.

7. Quelle nach einem der vorhergehenden Ansprüche, wobei:

- das Bandpassfilter (152) ein tertiäres Filter (154) aufweist, das mit dem primären Filter optisch in Reihe geschaltet ist, wobei das Übertragungsspektrum dieses tertiären Filters mehrere Durchlassbänder aufweist, die um einen Abstand $d_{SFR154}$ voneinander beabstandet sind, der wenigstens doppelt so groß wie ein Abstand $d_{SFR40}$ ist, wobei der Abstand $d_{SFR40}$ der Abstand ist, welcher die Durchlassbänder des Übertragungsspektrums des Interferometer (186; 246) des primären Filters voneinander trennt,
- dieses tertiäre Filter (154) einen Koeffizienten $d\lambda_{CF3}/dT$ aufweist, der zwischen $L_{min}$ und $L_{max}$ liegt, wobei:

• $\lambda_{CF3}$ eine Wellenlänge ist, die einem Maximum des Übertragungsspektrums des tertiären Filters entspricht,
• der Koeffizient $d\lambda_{CF3}/dT$ die Änderung der Wellenlänge $\lambda_{CF3}$ in Abhängigkeit von der Temperatur ist,
• $L_{min}$ gleich -50 pm/°C oder -15 pm/°C ist und
• $L_{max}$ gleich +50 pm/°C oder +15 pm/°C ist.

8. Quelle nach Anspruch 2 oder 7, wobei:

- die Durchlassbänder des sekundären (138) oder tertiären Filters (154) um einen solchen Abstand voneinander getrennt sind, dass im Inneren eines Intervalls $\Delta R$ nur ein einziges Durchlassband des sekundären oder tertiären Filters existiert, das um ein Übertragungsmaximum des Übertragungsspektrums des Interferometers des primären Filters zentriert ist, wobei das Intervall $\Delta R$ der kleinste Wellenlängenbereich ist, der alle möglichen Wellenlängen $\lambda_{Rj}$ enthält, die durch den Resonanzhohlraum zugelassen sind, und
- die Breite des Durchlassbandes des sekundären oder tertiären Filters, das um das Übertragungsmaximum des Übertragungsspektrums des Interferometers des primären Filters zentriert ist, kleiner oder gleich dem Intervall $\Delta\lambda_R$ ist.

9. Quelle nach Anspruch 2 oder 7, wobei:

- die Durchlassbänder des sekundären (228) oder tertiären Filters (154) um einen Abstand voneinander getrennt sind, der gleich einem ganzzahligen Vielfachen des Intervalls $\Delta\lambda_R$ und kleiner als ein Intervall $\Delta R$ ist, wobei das Intervall $\Delta R$ der kleinste Wellenlängenbereich ist, der alle möglichen Wellenlängen $\lambda_{Rj}$ enthält, die durch den Resonanzhohlraum zugelassen sind, und
- ein Durchlassband des sekundären oder tertiären Filters um ein Übertragungsmaximum des Übertragungsspektrums des Interferometers des primären Filters zentriert ist.

10. Verfahren zur Emission eines optischen Signals mit einer Wellenlänge $\lambda_{Li}$, die einer gewünschten Wellenlänge $\lambda_{Si}$ nahekommt, wobei dieses Verfahren umfasst:

a) die Bereitstellung einer Laserquelle, welche aufweist:

- eine Anordnung von Wellenleitern (15, 25, 28, 54), die optisch miteinander gekoppelt sind und einen optischen Resonator bilden, der in der Lage ist, ein optisches Signal mit mehreren möglichen Resonanzfrequenzen mitschwingen zu lassen, wobei die möglichen Wellenlängen $\lambda_{Rj}$ dieser möglichen Resonanzfrequenzen um ein Intervall $\Delta\lambda_R$ gleichmäßig voneinander beabstandet sind, wobei diese Anordnung aufweist:

• wenigstens einen Wellenleiter, in welchem ein Bandpassfilter (182; 242) realisiert ist, wobei das Übertragungsspektrum dieses Bandpassfilters ein Durchlassband aufweist, das in der Lage ist, aus den verschiedenen möglichen Wellenlängen $\lambda_{Rj}$ die Wellenlänge $\lambda_{Li}$ auszuwählen, die der Wellenlänge

$\lambda_{Si}$ am nächsten kommt, und
• wenigstens einen Verstärkungswellenleiter (28, 54), der in der Lage ist, bei jeder durch das Bandpassfilter ausgewählten Wellenlänge $\lambda_{Li}$ eine optische Verstärkung zu erzeugen, wobei dieser Verstärkungswellenleiter ein Verstärkungsmaterial III-V enthält,

wobei:
- das Bandpassfilter (182; 242) ein primäres Filter (184; 244) aufweist, das ein Mach-Zehnder-Interferometer (186, 246) enthält, wobei dieses Interferometer aufweist:

   • einen ersten und einen zweiten Arm (44, 46),
   • eine erste Verzweigung (48), an welcher das optische Signal zwischen dem ersten und dem zweiten Arm aufgeteilt wird, und
   • eine zweite Verzweigung (50), an welcher die optischen Signale des ersten und des zweiten Armes miteinander kombiniert werden,

- wobei der erste und der zweite Arm jeweils in mehrere aufeinander folgende Abschnitte ($S_{m,n}$) unterteilt sind, die unmittelbar aneinander angrenzen, wobei jeder Abschnitt einen Kern umfasst, der in der Lage ist, das optische Signal zu leiten, und jeder Abschnitt einen effektiven Index bei der Wellenlänge $\lambda_{Si}$ aufweist, wobei der effektive Index jedes Abschnitts, der sich unmittelbar nach einem vorangegangenen Abschnitt befindet, vom effektiven Index dieses vorangegangenen Abschnitts verschieden ist,
- wobei der erste und der zweite Arm jeweils einen Verstärkungsabschnitt ($S_{1,2}$, $S_{2,2}$) aufweisen, wobei die Kerne aller dieser Verstärkungsabschnitte aus demselben Verstärkungsmaterial III-V hergestellt sind und die Querabmessungen der Kerne dieser Verstärkungsabschnitte identisch sind, wobei diese Verstärkungsabschnitte somit einen ersten bzw. einen zweiten Verstärkungswellenleiter bilden,

b) während der Emission des optischen Signals werden ein erster und ein zweiter Gleichstrom durch den ersten bzw. zweiten Verstärkungswellenleiter injiziert (200), wobei die Stromstärken dieses ersten und zweiten Gleichstroms konstant und verschieden und so bemessen sind, dass die folgende Bedingung erfüllt ist:

$$\sum_{n=1}^{N_2} L_{2,n}\, neff_{2,n} - \sum_{n=1}^{N_1} L_{1,n}\, neff_{1,n} = k_f\, \lambda_{Si}$$

wobei:

   - $k_f$ eine vorbestimmte ganze Zahl größer oder gleich 1 ist,
   - $N_1$ und $N_2$ die Anzahlen der Abschnitte im ersten bzw. zweiten Arm sind,
   - $L_{1,n}$ und $L_{2,n}$ die Längen der n-ten Abschnitte des ersten bzw. zweiten Armes sind,
   - $neff_{1,n}$ und $neff_{2,n}$ die effektiven Indizes der n-ten Abschnitte des ersten bzw. zweiten Armes sind, wobei die effektiven Indizes der Verstärkungsabschnitte ($S_{1,2}$, $S_{2,2}$) von den Stromstärken des ersten und zweiten Gleichstroms abhängen.

## Claims

1. Semiconductor laser source able to emit at a wavelength $\lambda_{Li}$ close to a desired wavelength $\lambda_{Si}$, this laser source comprising:

   - a set of waveguides (15, 25, 28, 54) that are optically coupled to one another and that form an optical cavity able to make an optical signal resonate at a plurality of possible resonant frequencies, the possible wavelengths $\lambda_{Rj}$ of these possible resonant frequencies being regularly spaced apart from one another by an interval $\Delta\lambda_R$, this set comprising:

   • at least one waveguide in which a bandpass filter (182; 242) is produced, the transmission spectrum of this bandpass filter comprising a passband able to select, among the various possible wavelengths $\lambda_{Rj}$, the wavelength $\lambda_{Li}$ closest to the wavelength $\lambda_{Si}$, and
   • at least one gain-generating waveguide (28, 54) able to generate optical gain at each wavelength $\lambda_{Li}$

selected by the bandpass filter, this gain-generating waveguide comprising a III-V gain medium,

wherein:

- the bandpass filter (182; 242) comprises a primary filter (184; 244) containing a Mach-Zehnder interferometer (186; 246), this interferometer comprising:

  • first and second arms (44, 46),
  • a first fork (48) via which the optical signal is distributed between the first and second arms, and
  • a second fork (50) via which the optical signals of the first and second arms are combined together,

- each of the first and second arms being divided into a plurality of consecutive sections ($S_{m,n}$) that are immediately contiguous to one another, each section comprising a core able to guide the optical signal and each section having an effective index at the wavelength $\lambda_{Si}$, the effective index of each section located immediately after a preceding section being different from the effective index of this preceding section,
- the effective indices at the wavelength $\lambda_{Si}$ of the various sections of the first and second arms being such that the following first relationship is respected during the emission of the optical signal:

$$\sum_{n=1}^{N_2} L_{2,n}\, neff_{2,n} - \sum_{n=1}^{N_1} L_{1,n}\, neff_{1,n} = k_f\, \lambda_{Si}$$

where:

- $k_f$ is a preset integer number higher than or equal to 1,
- $N_1$ and $N_2$ are the numbers of sections in the first and second arms, respectively,
- $L_{1,n}$ and $L_{2,n}$ are the lengths of the nth sections of the first and second arms, respectively,
- $neff_{1,n}$ and $neff_{2,n}$ are the effective indices of the nth sections of the first and second arms, respectively,

**characterized in that**:

- the first and second arms each comprise a gain-generating section ($S_{1,2}$, $S_{2,2}$), the cores of each of these gain-generating sections being made from the same III-V gain medium and the transverse dimensions of the cores of these gain-generating sections being identical, these gain-generating sections thus forming a first gain-generating waveguide and a second gain-generating waveguide, respectively,
- the laser source comprises power sources (190, 192) that are able, during the emission of the optical signal, to inject first and second DC currents through the first and second gain-generating waveguides, respectively, the magnitudes of these first and second DC currents being constant and different and such that the first condition is met during the emission of the optical signal, the effective indices of the gain-generating sections ($S_{1,2}$, $S_{2,2}$) being dependent on the magnitudes of the first and second DC currents.

2. Source according to Claim 1, wherein:

- the primary filter (244) comprises a secondary filter (138) the transmission spectrum of which comprises a narrow passband located in the interior of a wider passband of the interferometer, this secondary filter having a coefficient $d\lambda_{CF2}/dT$ higher than $L_{max}$, where:

  • $\lambda_{CF2}$ is the wavelength corresponding to a maximum of the transmission spectrum of the secondary filter,
  • the coefficient $d\lambda_{CF2}/dT$ is the variation in the wavelength $\lambda_{CF2}$ as a function of temperature, and
  • $L_{max}$ is equal to 50 pm/°C or 15 pm/°C,

- one of the first and second arms of the interferometer comprises an optical coupling (142) to the secondary filter, and
- the lengths of the various sections of the first and second arms are such that a coefficient $d\lambda_{CMZI}/dT$ is comprised between $-d\lambda_{CF2}/dT + L_{min}$ and $-d\lambda_{CF2}/dT + L_{max}$, where:

- $\lambda_{CMZI}$ is a wavelength corresponding to a maximum of the transmission spectrum of the interferometer,
- the coefficient $d\lambda_{CMZI}/dT$ is the variation in the wavelength $\lambda_{CMZI}$ as a function of temperature,
- $L_{min}$ is equal to -50 pm/°C or -15 pm/°C, and
- $L_{max}$ is equal to +50 pm/°C or +15 pm/°C.

3. Source according to Claim 2, wherein the secondary filter comprises a ring resonator (140) optically coupled to one of the first and second arms of the interferometer (246), the narrow passband of the transmission spectrum of this ring resonator being centred on the wavelength $\lambda_{CMZI}$ and having a width $\Delta\lambda_{F2}$ smaller than or equal to the interval $\Delta\lambda_R$.

4. Source according to Claim 1, wherein:

   - none of the arms of the interferometer comprises an optical coupling to a secondary filter,
   - the lengths of the various sections of the first and second arms are such that a coefficient $d\lambda_{CMZI}/dT$ is comprised between $L_{min}$ and $L_{max}$ in a temperature range extending from 20° to 100°, where:

     - $\lambda_{CMZI}$ is a wavelength corresponding to a maximum of the transmission spectrum of the interferometer,
     - the coefficient $d\lambda_{CMZI}/dT$ is the variation in the wavelength $\lambda_{CMZI}$ as a function of temperature,
     - $L_{min}$ is equal to -50 pm/°C or -15 pm/°C, and
     - $L_{max}$ is equal to +50 pm/°C or +15 pm/°C.

5. Source according to Claim 4, wherein the lengths of the sections of the first and second arms meet the following athermicity condition for the wavelength $\lambda_{Si}$ and in a temperature range extending from 20° to 100°C:

$$L_{min} \leq \sum_{n=1}^{N_2} L_{2,n} \frac{d\,neff_{2,n}}{dT} - \sum_{n=1}^{N_1} L_{1,n} \frac{d\,neff_{1,n}}{dT} \leq L_{max}$$

where $dneff_{1,n}/dT$ and $dneff_{2,n}/dT$ are the variations in the effective indices of the nth sections of the first and second arms, respectively.

6. Source according to either one of Claims 4 and 5, wherein the first and second arms (44, 46) are structurally identical.

7. Source according to any one of the preceding claims, wherein:

   - the bandpass filter (152) comprises a tertiary filter (154) that is optically connected in series with the primary filter, the transmission spectrum of this tertiary filter comprising a plurality of passbands that are spaced apart from one another by a distance $d_{SFR154}$ at least two times larger than a distance $d_{SFR40}$, where the distance $d_{SFR40}$ is the distance that separates from one another the passbands of the transmission spectrum of the interferometer (186; 246) of the primary filter,
   - this tertiary filter (154) has a coefficient $d\lambda_{CF3}/dT$ comprised between $L_{min}$ and $L_{max}$, where:

     - $\lambda_{CF3}$ is a wavelength corresponding to a maximum of the transmission spectrum of the tertiary filter,
     - the coefficient $d\lambda_{CF3}/dT$ is the variation in the wavelength $\lambda_{CF3}$ as a function of temperature,
     - $L_{min}$ is equal to -50 pm/°C or -15 pm/°C, and
     - $L_{max}$ is equal to +50 pm/°C or +15 pm/°C.

8. Source according to Claim 2 or 7, wherein:

   - the passbands of the secondary or tertiary filter (138, 154) are separated from one another by a distance such that there exists, in the interior of an interval $\Delta R$, only a single passband of the secondary or tertiary filter, this passband being centred on a transmission maximum of the transmission spectrum of the interferometer of the primary filter, where the interval $\Delta R$ is the smallest wavelength range containing all the possible wavelengths $\lambda_{Rj}$ permitted by the resonant cavity, and
   - the width of the passband of the secondary or tertiary filter centred on the transmission maximum of the transmission spectrum of the interferometer of the primary filter is smaller than or equal to the interval $\Delta\lambda_R$.

**9.** Source according to Claim 2 or 7, wherein:

- the passbands of the secondary or tertiary filter (228, 154) are separated from one another by a distance equal to an integer multiple of the interval $\Delta\lambda_R$ and smaller than an interval $\Delta R$, where the interval $\Delta R$ is the smallest wavelength range containing all the possible wavelengths $\lambda_{Rj}$ permitted by the resonant cavity, and
- a passband of the secondary or tertiary filter is centred on a transmission maximum of the transmission spectrum of the interferometer of the primary filter.

**10.** Method for emitting an optical signal at a wavelength $\lambda_{Li}$ close to a desired wavelength $\lambda_{Si}$, this method comprising:

a) providing a laser source comprising:

- a set of waveguides (15, 25, 28, 54) that are optically coupled to one another and that form an optical cavity able to make an optical signal resonate at a plurality of possible resonant frequencies, the possible wavelengths $\lambda_{Rj}$ of these possible resonant frequencies being regularly spaced apart from one another by an interval $\Delta\lambda_R$, this set comprising:

  • at least one waveguide in which a bandpass filter (182; 242) is produced, the transmission spectrum of this bandpass filter comprising a passband able to select, among the various possible wavelengths $\lambda_{Rj}$, the wavelength $\lambda_{Li}$ closest to the wavelength $\lambda_{Si}$, and
  • at least one gain-generating waveguide (28, 54) able to generate optical gain at each wavelength $\lambda_{Li}$ selected by the bandpass filter, this gain-generating waveguide comprising a III-V gain medium,

wherein:

- the bandpass filter (182; 242) comprises a primary filter (184; 244) containing a Mach-Zehnder interferometer (186; 246), this interferometer comprising:

  • first and second arms (44, 46),
  • a first fork (48) via which the optical signal is distributed between the first and second arms, and
  • a second fork (50) via which the optical signals of the first and second arms are combined together,

- each of the first and second arms being divided into a plurality of consecutive sections ($S_{m,n}$) that are immediately contiguous to one another, each section comprising a core able to guide the optical signal and each section having an effective index at the wavelength $\lambda_{Si}$, the effective index of each section located immediately after a preceding section being different from the effective index of this preceding section,
- the first and second arms each comprising a gain-generating section ($S_{1,2}$, $S_{2,2}$), the cores of each of these gain-generating sections being made from the same III-V gain medium and the transverse dimensions of the cores of these gain-generating sections being identical, these gain-generating sections thus forming a first gain-generating waveguide and a second gain-generating waveguide, respectively,

b) during the emission of the optical signal, first and second DC currents are injected (200) through the first and second gain-generating waveguides, respectively, the magnitudes of these first and second currents being constant and different and such that the following condition is met:

$$\sum_{n=1}^{N_2} L_{2,n}\, neff_{2,n} - \sum_{n=1}^{N_1} L_{1,n}\, neff_{1,n} = k_f\, \lambda_{Si}$$

where:

- $k_f$ is a preset integer number higher than or equal to 1,
- $N_1$ and $N_2$ are the numbers of sections in the first and second arms, respectively,
- $L_{1,n}$ and $L_{2,n}$ are the lengths of the nth sections of the first and second arms, respectively,
- $neff_{1,n}$ and $neff_{2,n}$ are the effective indices of the nth sections of the first and second arms, respectively, the effective indices of the gain-generating sections ($S_{1,2}$, $S_{2,2}$) being dependent on the magnitudes of the first and second DC currents.

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2018261976 A
- US 20140254617 A1
- US 20030123784 A1
- CN 103368678 B
- US 2016301191 A1
- US 2012057079 A1
- WO 2007107187 A1
- US 20180261976 A

**Littérature non-brevet citée dans la description**

- **AMNON YARIV et al.** Supermode Si/III-V hybrid Lasers, optical amplifiers and modulators: proposai and analysis. *Optics Express 9147,* 23 Juillet 2007, vol. 14 (15
- **DIMITRIS FITSIOS et al.** High-gain 1,3 µm GaInNAs semiconductor optical amplifier with enchanced temperature stability for all-optical processing at 10 Gb/s. *Applied optics,* 01 Janvier 2015, vol. 54 (1
- **BISWAJEET GUHA et al.** Minimizing temperature sensitivity of silicon Mach-Zehnder interferometers. *Optics Express,* 15 Janvier 2010, 1879-1887
- **BISWAJEET GUHA et al.** CMOS-compatible athermal silicon microring resonators. *Optics Express,* 03 Février 2010, 3487-3493
- **G. H. DUAN et al.** Hybrid III-V on Silicon Lasers for Photonic Integrated Circuits on Silicon. *Journal of Selected Topics in Quantum Electronics,* Juillet 2014, vol. 20 (4), 1-13